(19) Europäisches Patentamt
European Patent Office
Office européen des brevets

(11) **EP 4 002 342 B1**

(12) **EUROPEAN PATENT SPECIFICATION**

(45) Date of publication and mention
of the grant of the patent:
**04.03.2026 Bulletin 2026/10**

(21) Application number: **20927480.2**

(22) Date of filing: **25.03.2020**

(51) International Patent Classification (IPC):
*G09G 3/36* (2006.01)    *G02F 1/13* (2006.01)
*G09G 3/20* (2006.01)    *G09G 3/3233* (2016.01)
*H10K 59/131* (2023.01)

(52) Cooperative Patent Classification (CPC):
**H04M 1/0266; G09G 3/20; H10K 59/131;**
G09G 3/3233; G09G 3/3266; G09G 2300/0426;
G09G 2300/0861; G09G 2310/0251; H04M 1/0264

(86) International application number:
**PCT/CN2020/081234**

(87) International publication number:
**WO 2021/189334 (30.09.2021 Gazette 2021/39)**

(54) **DISPLAY PANEL AND DISPLAY DEVICE**

ANZEIGETAFEL UND ANZEIGEVORRICHTUNG

PANNEAU D'AFFICHAGE ET DISPOSITIF D'AFFICHAGE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**25.05.2022 Bulletin 2022/21**

(73) Proprietors:
• **BOE Technology Group Co., Ltd.**
**Beijing 100015 (CN)**
• **Chengdu BOE Optoelectronics Technology Co.,
Ltd.**
**Chengdu, Sichuan 611731 (CN)**

(72) Inventors:
• **ZHOU, Yang**
**Beijing 100176 (CN)**
• **HUANG, Yao**
**Beijing 100176 (CN)**
• **ZHANG, Yiyang**
**Beijing 100176 (CN)**
• **ZHANG, Hao**
**Beijing 100176 (CN)**
• **HAN, Linhong**
**Beijing 100176 (CN)**

(74) Representative: **Brötz, Helmut et al
Rieder & Partner mbB
Patentanwälte - Rechtsanwalt
Yale-Allee 26
42329 Wuppertal (DE)**

(56) References cited:
CN-A- 1 873 509     CN-A- 108 983 463
CN-A- 109 767 689     CN-A- 110 208 994
CN-A- 110 518 022     CN-U- 206 610 047
CN-U- 208 444 534     JP-A- 2000 267 590
TW-A- 202 006 449     US-A1- 2009 262 270
US-A1- 2019 243 202     US-A1- 2019 285 954
US-A1- 2019 319 212

**Description**

TECHNICAL FIELD

Embodiments of the present disclosure relate to a display panel and a display device.

BACKGROUND

With the increasing requirements of users on the screen-to-body ratio of electronic apparatus products, flexible panels have been developed in various forms such as forming a groove or forming a hole. Before the technology of under-screen camera in the normal display region is matured, the more mature technology with the highest screen-to-body ratio at present is the technology of forming a hole within the screen.
CN110208994A discloses a liquid crystal display panel and a display device. The liquid crystal display panel comprises a display region and a hollow functional region, wherein the display region is formed around the hollow functional region; and a first transition region is formed between the hollow functional region and the display region, and the first transition region surrounds the hollow functional region. The liquid crystal display panel further comprises a data signal line and a scanning signal line, wherein the data signal line and the scanning signal line are arranged around the hollow functional region in the first transition region; vertical projection of the data signal line in a first plane overlaps vertical projection of the scanning signal line in the first plane at a plurality of coincident points in the first transition region; and the first plane is a plane on which the surface of a light emergent side of the liquid crystal display panel locates, and the at least one coincident point is arranged within vertical projection of an auxiliary metal electrode in the first plane. According to the liquid crystal display panel and the display device, the auxiliary metal electrode is additionally arranged at a position wherein the data signal line and the scanning signal line overlap, so as to increase the load of the scanning signal line, avoid display unevenness, and improve the display effect. CN109767689A discloses a display substrate and a display panel, and belongs to the technical field of displaying. The display substrate is provided with a plurality of first regions arrayed along a row direction; a plurality of first signal lines arrayed along the row direction are arranged in the first region; at least part of the first regions comprise blank regions and blank border regions surrounding the blank regions; in the first regions having the blank regions and the blank border regions, part of the first signal lines comprise first signal sections and first connection sections electrically connected with the first signal sections; the first signal sections and the first connection sections are arranged on the same layer; part of the first signal lines comprise first signal sections and second connection sections electrically connected with the first signal sections; insulating layers are arranged between the first signal sections and the second connection sections, and the first signal sections and the second connection sections are electrically connected through via holes in the insulating layers; the first connection sections and the second connection sections are located in the blank border regions.
US2019/285954 A1 discloses a liquid crystal display panel which allows for the area of a wiring diverting region to be reduced. A liquid crystal display panel includes: a substrate having a displaying region and a non-displaying region; a plurality of first wires provided in a first layer; a plurality of second wires which are provided in a second layer differing from the first layer; a plurality of touch panel lines which are provided in a third layer differing from both the first and second layers; a plurality of touch panel electrodes each of which is connected to a respective one of the plurality of touch panel lines; and a sensing section which is provided at a first end of the substrate and connected to the plurality of touch panel lines, out of those of the plurality of touch panel lines connected to those of the plurality of touch panel electrodes located farther away from the sensing section than is the non-displaying region, at least one touch panel line being provided so as to run from the sensing section to a second end of the substrate and, at the second end, turn back toward the plurality of touch panel electrodes.
US 2019/319212 A1 discloses an insulating substrate in which at least one hole is defined, wherein the insulating substrate comprises a hole area in which the hole is defined, a display area surrounding the hole area, and a peripheral area adjacent to the display area, a plurality of pixels in the display area, a plurality of main signal lines in the display area and electrically connected to the pixels, and a plurality of sub-signal lines in the hole area and electrically connected to the pixels, wherein the hole area comprises a line area which surrounds the hole and in which the sub-signal lines are located, and a compensation area between the line area and the display area in a plan view and configured to display a black color.

SUMMARY

It is an object of the present invention to provide a display panel and a display device.
The object is achieved by the features of the respective independent claims. Further embodiments are defined in the corresponding dependent claims.

BRIEF DESCRIPTION OF THE DRAWINGS

In order to clearly illustrate the technical solution of the embodiments of the present disclosure, the drawings of the embodiments will be briefly described in the following. It is obvious that the described drawings are only related to some embodiments of the present disclosure and thus are not construed any limitation to the present disclosure.

FIG. 1 is a schematic diagram of a display panel;
FIG. 2 is a schematic diagram of a display panel;
FIG. 3 is a schematic diagram of a display panel;
FIG. 4 is a schematic diagram of a display panel;
FIG. 5 is a partial view of a display panel;
FIG. 6 is a schematic diagram of signal lines providing signals for each pixel unit in a display panel provided by an embodiment of the present disclosure;
FIG 7 is a partial plan view of a display panel provided by an embodiment of the present disclosure;
FIG 8 is a plan view of a data line in FIG 7;
FIG 9 is a plan view of a gate line and a light emitting control signal line in FIG 7;
FIG 10 is a cross-sectional view taken along line A-B in FIG 7;
FIG 11 is a cross-sectional view of a display panel provided by an embodiment of the present disclosure;
FIG 12 is a plan view of a display panel provided by an embodiment of the present disclosure;
FIG 13 is a plan view of a third conductive pattern layer and a fourth conductive pattern layer in a display panel provided by an embodiment of the present disclosure;
FIG 14 is a plan view of a fourth conductive pattern layer in a display panel provided by an embodiment of the present disclosure;
FIG 15 is a cross-sectional view of a display panel provided by an embodiment of the present disclosure;
FIG 16 is a plan view of an initialization signal line and a second conductive line in a display panel provided by an embodiment of the present disclosure;
FIG 17 is a cross-sectional view of a display panel provided by an embodiment of the present disclosure;
FIG 18 is a cross-sectional view of a display panel provided by an embodiment of the present disclosure;
FIG 19 is a partial view of a display panel provided by an embodiment of the present disclosure;
FIG 20 is a partial view of a display panel provided by an embodiment of the present disclosure;
FIG 21 is a partial view of a display panel provided by an embodiment of the present disclosure;
FIG 22 is a schematic diagram of a display panel provided by an embodiment of the present disclosure;
FIG 23 is a schematic diagram of a display panel provided by an embodiment of the present disclosure;
FIG 24 is a partial view of FIG 23;
FIG 25 is a plan view of a dummy pixel unit at a second portion of a bezel region gate line;
FIG 26 is a pattern of an active layer of the dummy pixel unit in FIG 25;
FIG 27 is a pattern of a first conductive pattern layer of the dummy pixel unit in FIG 25;
FIG 28 is a pattern of a second conductive pattern layer of the dummy pixel unit in FIG 25;
FIG 29 is a pattern of an insulation layer of the dummy pixel unit in FIG 25;
FIG 30 is a pattern of a third conductive pattern layer of the dummy pixel unit in FIG 25;
FIG 31 is a schematic diagram of a pixel circuit structure of a display panel provided by an embodiment of the present disclosure;
FIG 32 is a timing signal diagram of a pixel unit in a display panel provided by an embodiment of the present disclosure; and
FIG 33 is a plan view of a display substrate provided by an embodiment of the present disclosure.

DETAILED DESCRIPTION

For more clear understanding of the objectives, technical details and advantages of the embodiments of the present disclosure, the technical solutions of the embodiments will be described in a clearly and fully understandable way in connection with the drawings related to the embodiments of the present disclosure. Apparently, the described embodiments are just a part but not all of the embodiments of the present disclosure. Based on the described embodiments herein, those skilled in the art can obtain other embodiment(s), without any inventive work, which should be within the scope of the present disclosure.

Unless otherwise defined, all the technical and scientific terms used herein have the same meanings as commonly understood by one of ordinary skill in the art to which the present disclosure belongs. The terms "first," "second," etc., which are used in the present disclosure, are not intended to indicate any sequence, amount or importance, but distinguish various components. Also, the terms "comprise", "comprising", "include", "including", etc., are intended to specify that the elements or the objects stated before these terms encompass the elements or the objects and equivalents thereof listed after these terms, but do not preclude the other elements or objects. The phrases "connect", "connected" and the like are not limited to a physical or mechanical connection, but also include an electrical connection, either directly or indirectly. "On," "under," "right," "left" and the like are only used to indicate relative position relationship, and when the position of the described object is changed, the relative position relationship may be changed accordingly.

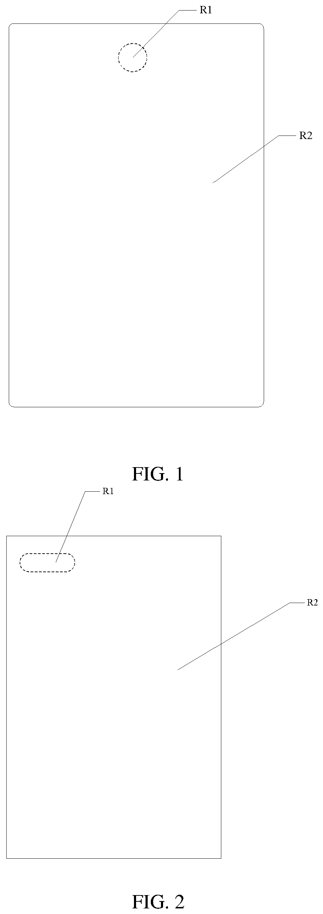

FIG 1 is a schematic diagram of a display panel. As illustrated in FIG 1, the display panel includes a light transmission region R1 and a display region R2. In the case where the scheme of forming a hole within the screen is adopted, at least part of the structure in the light transmission region R1 is removed, that is, the scheme of forming a hole within the screen needs to sacrifice part of the display region to form the light transmission region. As illustrated in FIG 1, the light transmission region R1 is circular. The light transmission region R1 is a region where a hole is formed. The size of the region where a hole is formed determines the number of display pixel units missing from the current display pixel unit row. The more the number of the missing display pixel units, the more the missing load of the gate line (scan signal), and the more capacitance needed to be compensated for the scan signal.

FIG 2 is a schematic diagram of a display panel. The shape of the light transmission region R1 of the display panel illustrated in FIG 2 is different from that of the light transmission region R1 of the display panel illustrated in FIG 1. As illustrated in FIG 2, the light transmission region R1 has a racetrack shape. The shape of the light transmission region R1 of the display panel provided by the embodiment of the present disclosure is not limited to the shapes illustrated in FIG 1 and FIG 2, and can be arranged as needed. The arrangement position of the light transmission region R1 of the display panel provided by the embodiments of the present disclosure is not limited to those illustrated in the figures, and can be arranged as needed. The following embodiments of the present disclosure are described with reference to the case where the shape of the light transmission region R1 is circular.

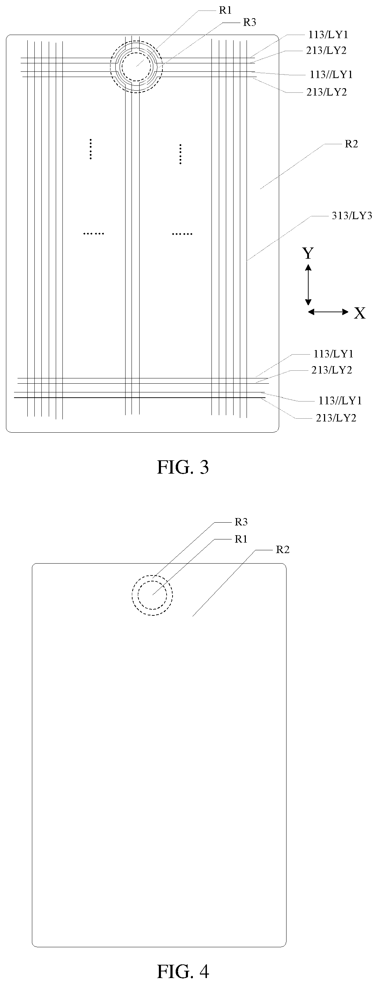

FIG 3 is a schematic diagram of a display panel. As illustrated in FIG 3, a hole needs to be formed in the light transmission region R1, the trace lines that should have been arranged in this region in the case where a hole is not formed need to extend along the edge of the light transmission region R1 in the case where a hole is formed, thus forming a bezel region R3. As illustrated in FIG 3, the bezel region R3 is located between the display region R2 and the light transmission region R1. The display region R2 surrounds the light transmission region R1, and the bezel region R3 surrounds the light transmission region R1. Of course, in some other embodiments, the display region R2 can be located at a side of the light transmission region R1, and the bezel region R3 can be located between the display region R2 and the light transmission region R1. FIG 3 illustrates data lines 313, gate lines 113 and light emitting control signal lines 213.

As illustrated in FIG 3, the gate line 113 is located in a first conductive pattern layer LY1, the light emitting control signal line 213 is located in a second conductive pattern layer LY2, and the data line 313 is located in a third conductive pattern layer LY3. Of course, in some other embodiments, the light emitting control signal line 213 can also be located in the first conductive pattern layer LY1.

FIG 3 illustrates a first direction X and a second direction Y. As illustrated in FIG 3, the data line 313 extends along the second direction Y, and both the gate line 113 and the light emitting control signal line 213 extend along the first direction X. The extending direction of each signal line described here refers to an overall extending trend of the signal line, and it is not excluded that the signal line includes parts that do not extend along this direction.

All signal lines are not illustrated in FIG 3, and the display panel provided by the embodiments of the present disclosure can further include other signal lines. For example, the display panel provided by the embodiments of the present disclosure can further include signal lines such as a power line and an initialization signal line, etc.

FIG 4 is a schematic diagram of a display panel. FIG 4 illustrates a light transmission region R1, a display region R2 and a bezel region R3. And for the sake of clarity, the signal lines are omitted.

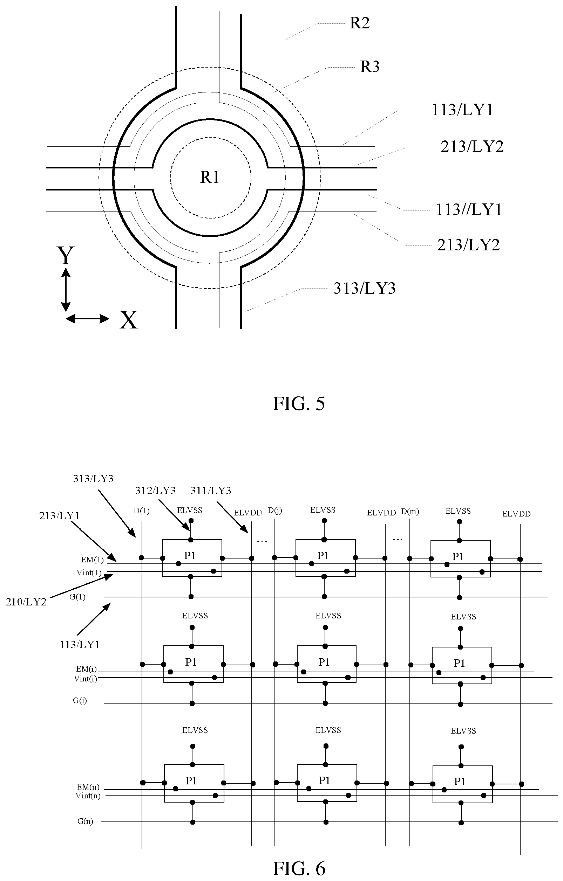

FIG 5 is a partial view of a display panel. FIG 5 is a schematic diagram of a light transmission region R1 and the structure in the vicinity thereof. FIG 5 illustrates four data lines 313, two gate lines 113, and two light emitting control signal lines 213.

On the one hand, forming a hole within the screen not only causes missing of the pixel circuits, but also causes missing of loading in the lateral and vertical direction in the region where a hole is formed (light transmission region R1). However, the missing load is not compensated in the common design. According to the design experience of the irregular screen that is grooved, the missing load may lead to display difference at the boundary of the missing pixel units, such as a display defect that the lateral range where the hole is located is dark. At present, in the hole-forming design of the panel appearing in the market, due to the small hole size, the display difference problem of a conventional display image may not be exposed, but the display defect will occur under a more strict display condition (e.g., high refresh rate). For another example, the whole product manufacturer needs more camera sensors to be disposed in the front, and needs to design a racetrack-shape hole at the same row position, so that the missing load is more, and the display defect is more easily exposed.

On the other hand, a plurality of signal lines are formed in the bezel region, and the space occupied by the signal lines affects the size of the bezel region, which is not conducive to increasing the screen-to-body ratio.

FIG 6 is a schematic diagram of signal lines providing signals for each pixel unit in a display panel provided by an embodiment of the present disclosure. Each display pixel unit P1 includes a light emitting unit and a pixel circuit structure that provides a driving current for the light emitting unit. The light emitting unit can be an electroluminescent unit, such as an organic electroluminescent unit, for example, an organic light emitting diode (OLED). The display pixel unit P1 is a pixel unit that emits light normally. The display pixel unit P1 is located in the display region R2.

FIG 6 illustrates gate lines 113, data lines 313, first power lines 311, second power lines 312, light emitting control signal lines 213 and initialization signal lines 210. For example, the gate line 113 is configured to provide at least one of a scan signal SCAN or a reset signal RESET to the pixel circuit structure, and in the case where the gate line 113 is configured to provide a reset signal RESET to the pixel circuit structure, it can also be referred to as a reset control signal line. For example, in the display panel, the second reset control signal line 112 of the pixel units of a current row serves as the first reset control signal line 111 of the pixel units of a next row. The light emitting control signal line 213 is configured to provide a light emitting control signal EM to the display pixel unit P1. The data line 313 is configured to provide a data signal DATA to the pixel circuit structure 10, the first power line 311 is configured to provide a first voltage signal ELVDD that is constant to the pixel circuit structure 10, the second power line 312 is configured to provide a second voltage signal ELVSS that is constant to the pixel circuit structure 10, and the first voltage signal ELVDD is greater than the second voltage signal ELVSS. The initialization signal line 210 is configured to provide an initialization signal Vint to the pixel circuit structure. The initialization signal Vint is a constant voltage signal, and the magnitude thereof can be between the first voltage signal ELVDD and the second voltage signal ELVSS, but is not limited thereto. For example, the initialization signal Vint can be less than or equal to the second voltage signal ELVSS. For example, the pixel circuit structure outputs a driving current to drive the light emitting unit to emit light under the control of signals, such as the scan signal SCAN, the data signal DATA, the initialization signal Vint, the first voltage signal ELVDD, the second voltage signal ELVSS, the light emitting control signal EM, etc.

For example, as illustrated in FIG 6, the gate line 113 is located in the first conductive pattern layer LY1, the initialization signal line 210 is located in the second conductive pattern layer LY2, the data line 313 and the first power line 311 are located in the third conductive pattern layer LY3, and the second power line 312 can also be located in the third conductive pattern layer LY3.

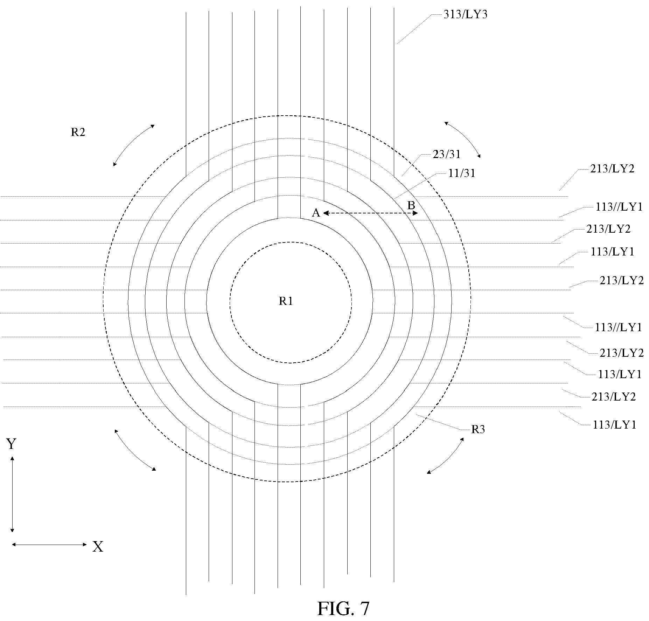

FIG 7 is a partial plan view of a display panel provided by an embodiment of the present disclosure. As illustrated in FIG 7, the display panel includes a light transmission region R1, a display region R2, a bezel region R3, a plurality of light emitting control signal lines 213, a plurality of data lines 313, and a plurality of gate lines 113.

As illustrated in FIG 7, the display region R2 is arranged around the light transmission region R1 or at a side of the light transmission region R1. The bezel region R3 is located between the light transmission region R1 and the display region R2.

For example, referring to FIG 6 and FIG 7, the number of the plurality of light emitting control signal lines 213 is equal to the number of the plurality of gate lines 113. That is, one light emitting control signal line 213 is provided for each row of pixel units, and the light emitting control signal is used for progressive driving, thereby alleviating the dimming flicker problem in low gray-scale. In this case, if the number of horizontal signal lines is equal to the number of vertical signal lines in the bezel region R3 and the light transmission region R1 is circular, the bezel region R3 can be annular, but is not limited thereto.

As illustrated in FIG 7, in the bezel region R3, one gate line 113 overlaps with one data line 313 at a first position and overlaps with another data line 313 at a second position. As illustrated in FIG 7, in the bezel region R3, one light emitting control signal line 213 overlaps with one data line 313 at a third position and overlaps with another data line 313 at a fourth position. As illustrated in FIG 7, in the bezel region R3, one data line 313 overlaps with one light emitting control signal line 213 at a fifth position and overlaps with one gate line 113 at a sixth position.

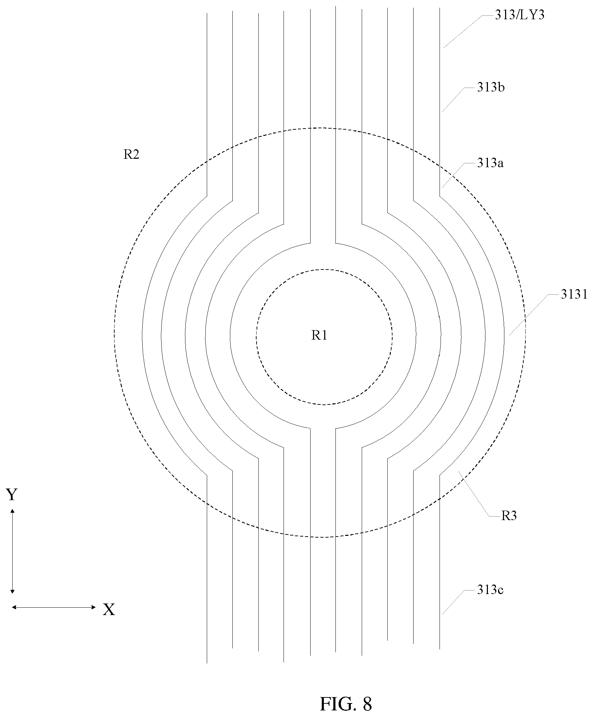

FIG 8 is a plan view of the data line in FIG 7. Referring to FIG 7 and FIG 8, the plurality of data lines 313 are located on the base substrate, and include a plurality of bezel region data lines 313a located in the bezel region R3 and a plurality of display region data lines 313b located in the display region R2, and the plurality of bezel region data lines 313a are connected with the plurality of display region data lines 313b, respectively. Each data line 313 includes a bezel region data line 313a located in the bezel region R3 and a display region data line 313b located in the display region R2. FIG 8 further illustrates a plurality of display region data lines 313c, and the plurality of display region data lines 313c are connected with a plurality of bezel region data lines 313a, respectively. In this case, each data line 313 includes a bezel region data line 313a located in the bezel region R3, a display region data line 313b located in the display region R2 and a display region data line 313c located in the display region R2. The display region data line 313b and the display region data line 313c are disposed at both sides of the bezel region data line 313a, respectively.

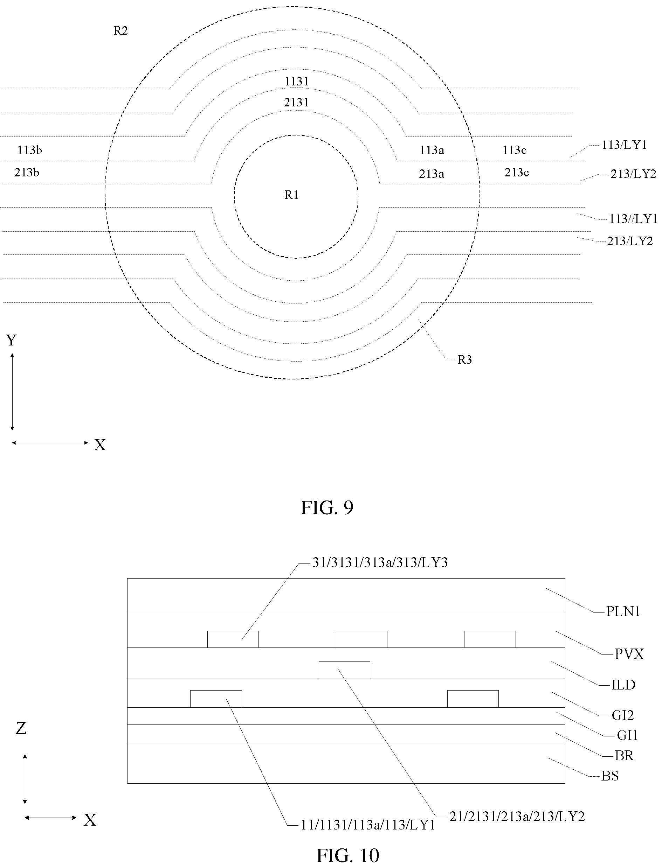

FIG 9 is a plan view of the gate line and the light emitting control signal line in FIG 7. Referring to FIG 7 and FIG 9, the plurality of gate lines 113 are located on the base substrate, and include a plurality of bezel region gate lines 113a located in the bezel region R3 and a plurality of display region gate lines 113b located in the display region R2, and the plurality of bezel region gate lines 113a are connected with the plurality of display region gate lines 113b, respectively. Each gate line 113 includes a bezel region gate line 113a located in the bezel region R3 and a display region gate line 113b located in the display region R2. FIG 9 further illustrates a plurality of display region gate lines 113c, and the plurality of display region gate lines 113c are connected with a plurality of bezel region gate lines 113a, respectively. In this case, each gate line 113 includes a bezel region gate line 113a located in the bezel region R3, a display region gate line 113b located in the display region R2 and a display region gate line 113c located in the display region R2. The display region gate line 113b and the display region gate line 113c are disposed at both sides of the bezel region gate line 113a, respectively.

Referring to FIG 7 to FIG 9, the bezel region gate line 113a includes a first portion 1131, and the bezel region data line 313a includes a first portion 3131, the extending direction of the first portion 1131 of the bezel region gate line 113a is the same as the extending direction of the first portion 3131 of the bezel region data line 313a, and the first portion 1131 of the bezel region gate line 113a overlaps with the first portion 3131 of one of the plurality of bezel region data lines 313a in a direction perpendicular to the base substrate. For example, the same extending direction may refer to that two elements have conformal parts, and the conformal parts have the same extending direction, or the conformal parts have the same extending trend. For example, the same extending direction may refer to that two elements extend in the same direction at the same point. For example, the same extending direction may refer to a general extending trend of the line, and in the case where the line is not a straight line, the tangent direction of the line can be the extending direction thereof. The same extending direction includes the extending direction are completely the same and approximately the same. In FIG 7, the extending directions of overlapping parts of different elements are illustratively described by curves with double-arrows.

FIG 10 is a cross-sectional view taken along line A-B in FIG 7. As illustrated in FIG 10, the display substrate includes a base substrate BS. A barrier layer BR is provided on the base substrate BS, a first gate insulation layer GI1 is provided on the barrier layer BR, a first conductive pattern layer LY1 is provided on the first gate insulation layer GI1, and the first conductive pattern layer LY1 includes the gate line 113. A second gate insulation layer GI2 is provided on the first conductive pattern layer LY1, a second conductive pattern layer LY2 is provided on the second gate insulation layer GI2, and the second conductive pattern layer LY2 includes the light emitting control signal line 213. An interlayer insulation layer ILD is provided on the second conductive pattern layer LY2. A third conductive pattern layer LY3 is provided on the interlayer insulation layer ILD, and the third conductive pattern layer LY3 includes the data line 313. A passivation layer PVX and a first planarization layer PLN1 are provided on the third conductive pattern layer LY3.

FIG 10 illustrates a third direction Z. The third direction Z is perpendicular to the first direction X. The third direction Z is also perpendicular to the second direction Y. And the third direction Z is the direction perpendicular to the base substrate BS. Referring to FIG 7 to FIG 10, the first portion 1131 of the bezel region gate line 113a overlaps with the first portion 3131 of one of the plurality of bezel region data lines 313a in the direction perpendicular to the base substrate BS.

According to the previous test experience and simulation results, the load difference of gate lines has the greatest influence on the display panel, and the load affects the rising edge time and the falling edge time of the scan signal SCAN, thus affecting the writing time of the data signal DATA. The difference of writing time of the data signal DATA directly leads to the brightness difference of the display panel. Therefore, the gate line and the data line are overlapped to form two electrode plates of a capacitor, respectively, which compensates for the missing load of the gate line, reduces the brightness difference of the display panel and improves the display effect. In the display panel provided by the embodiments of the present disclosure, the panel display difference caused by hole-forming is corrected, and the display quality is improved.

For example, referring to FIG 7 and FIG 10, the part 11 of the bezel region gate line 113a overlapping with the bezel region data line 313a is a part of the first portion 1131 of the bezel region gate line 113a, and the width of the part 11 of the bezel region gate line 113a overlapping with the bezel region data line 313a is less than or equal to the width of the bezel region data line 313a.

For example, referring to FIG 7 and FIG 8, the part 31 of the bezel region data line 313a overlapping with the bezel region gate line 113a is a part of the first portion 3131 of the bezel region data line 313a. The length of the part 31 of the bezel region data line 313a overlapping with the bezel region gate line 113a along the extending direction of the part 31 of the bezel region data line 313a is less than the length of the first portion 3131 of the bezel region data line 313a.

In the embodiments of the present disclosure, the length of an element can refer to its size in the extending direction thereof, and the width of an element can refer to its size in a direction perpendicular to the extending direction thereof.

For example, referring to FIG 7 and FIG 9, the length of the part 11 of the bezel region gate line 113a overlapping with the bezel region data line 313a along the extending direction of the part 11 of the bezel region gate line 113a is less than the length of the first portion 1131 of the bezel region gate line 113a.

For example, referring to FIG 7, the length of the part 11 of the bezel region gate line 113a overlapping with the bezel region data line 313a along the extending direction of the part 11 of the bezel region gate line 113a is greater than the width of the bezel region data line 313a.

For example, referring to FIG 7 and FIG 9, the first portion 1131 of the bezel region gate line 113a includes a curved portion, and the first portion 3131 of the bezel region data line 313a includes a curved portion. For example, the curved portion of the bezel region gate line 113a and the curved portion of the bezel region data line 313a both include an arc shape.

For example, referring to FIG 7, along a direction pointing from a position away from the light transmission region

R1 to a position close to the light transmission region R1, the length of the part of the bezel region gate line 113a overlapping with the bezel region data line 313a gradually increases.

For example, referring to FIG 7, FIG 9 and FIG 10, the display panel further includes a plurality of light emitting control signal lines 213, the plurality of light emitting control signal lines 213 include a plurality of bezel region light emitting control signal lines 213a located in the bezel region R3 and a plurality of display region light emitting control signal lines 213b located in the display region R2, and the plurality of bezel region light emitting control signal lines 213a are connected with the plurality of display region light emitting control signal lines 213b, respectively. The bezel region light emitting control signal line 213a includes a first portion 2131, the extending direction of the first portion 2131 of the bezel region light emitting control signal line 213a is the same as the extending direction of the first portion 3131 of the bezel region data line 313a, and the first portion 2131 of the bezel region light emitting control signal line 213a overlaps with the first portion 3131 of one of the plurality of bezel region data lines 313a in the direction perpendicular to the base substrate BS. Therefore, the light emitting control signal line and the data line are overlapped to form two electrode plates of a capacitor, respectively, thus compensating the missing load of the light emitting control signal line and improving the display effect.

For example, as illustrated in FIG 9, each light emitting control signal line 213 includes a bezel region light emitting control signal line 213a located in the bezel region R3 and a display region light emitting control signal line 213b located in the display region R2.

For example, as illustrated in FIG 9, the plurality of light emitting control signal lines 213 further include a plurality of display region light emitting control signal lines 213c located in the display region R2, and the plurality of display region light emitting control signal lines 213c are connected with the plurality of bezel region light emitting control signal lines 213a, respectively. Each light emitting control signal line 213 includes a bezel region light emitting control signal line 213a located in the bezel region R3, a display region light emitting control signal line 213b located in the display region R2, and a display region light emitting control signal line 213c located in the display region R2. The display region light emitting control signal line 213b and the display region light emitting control signal line 213c are disposed at both sides of the bezel region light emitting control signal line 213a, respectively.

For example, referring to FIG 7 and FIG 9, the length of the part 21 of the bezel region light emitting control signal line 213a overlapping with the bezel region data line 313a along the extending direction of the part 21 of the bezel region light emitting control signal line 213a is less than the length of the first portion 1131 of the bezel region light emitting control signal line 213a.

For example, as illustrated in FIG 7, the length of the part 21 of the bezel region light emitting control signal line 213a overlapping with the bezel region data line 313a along the extending direction of the part 21 of the bezel region light emitting control signal line 213a is greater than the width of the bezel region data line 313a.

For example, referring to FIG 7 and FIG 9, the first portion 2131 of the bezel region light emitting control signal line 213a includes a curved portion. For example, the curved portion of the bezel region light emitting control signal line 213a and the curved portion of the bezel region data line 313a both include an arc shape.

For example, as illustrated in FIG 7, along the direction pointing from a position away from the light transmission region R1 to a position close to the light transmission region R1, the length of the part of the bezel region light emitting control signal line 213a overlapping with the bezel region data line 313a gradually increases.

For example, as illustrated in FIG 7, a plurality of portions 21 of the bezel region light emitting control signal lines 213a overlapping with the bezel region data lines 313a are alternately arranged with a plurality of portions 11 of the bezel region gate lines 113a overlapping with the bezel region data lines 313a. That is, the plurality of portions 21 and the plurality of portions 11 are alternately arranged.

FIG 7 is illustrated by taking that the first portion 1131 of the bezel region gate line 113a is a part of a circle, the first portion 3131 of the bezel region data line 313a is a part of a circle and the first portion 2131 of the bezel region light emitting control signal line 213a is a part of a circle as an example, which is not limited to this case. In some other embodiments, the first portion 1131 of the bezel region gate line 113a can also adopt other curved forms, the first portion 3131 of the bezel region data line 313a can also adopt other curved forms, and the first portion 2131 of the bezel region light emitting control signal line 213a can also adopt other curved forms.

FIG 7 and FIG 10 are illustrated by taking that adjacent data lines 313 are located in the same layer, that is, the data lines 313 that are adjacent to each other are located in the third conductive pattern layer LY3, as an example, but are not limited thereto. For example, in some other embodiments, the bezel region data lines 313a that are adjacent to each other and illustrated in FIG 7 and FIG 10 can also be located in different layers.

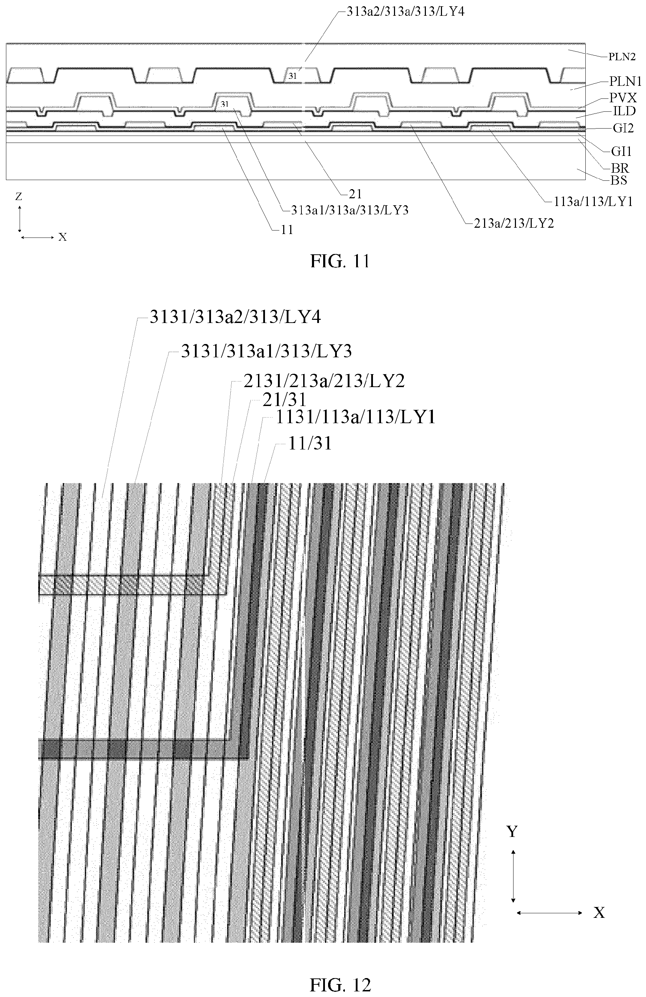

FIG 11 is a cross-sectional view of a display panel provided by an embodiment of the present disclosure. As illustrated in FIG 11, the bezel region data lines 313a that are adjacent to each other are located in different layers, thereby reducing the space occupied by the signal lines in the bezel region at the periphery of the light transmission region, and realizing a narrow bezel and a higher screen-to-body ratio. For example, as illustrated in FIG 11, the bezel region data lines 313a that are adjacent to each other include a first bezel region data line 313a1 and a second bezel region data line 313a2, the first bezel region data line 313a1 is closer to the base substrate BS than the second bezel region data line 313a2, and an insulation layer is disposed between the first bezel region data line 313a1 and the second bezel region data line 313a2.

For example, the insulation layer includes a passivation layer PVX and a first planarization layer PLN1.

For example, in the embodiments of the present disclosure, the light emitting control signal line 213 can be located in the second conductive pattern layer LY2, but is not limited thereto. In some other embodiments, the light emitting control signal line 213 can be formed in segments; for example, the bezel region light emitting control signal line 213a is located in the second conductive pattern layer LY2, while a part of the light emitting control signal line 213 other than the bezel region light emitting control signal line 213a is located in the first conductive pattern layer LY1. For example, as illustrated in FIG 9, the display region light emitting control signal line 213b is located in the first conductive pattern layer LY1, while the bezel region light emitting control signal line 213a is located in the second conductive pattern layer LY2. For example, only the part of the light emitting control signal lines 213 in the vicinity of the light transmission region R1 are formed in segments, and the light emitting control signal lines 213 at other positions can all be located in the first conductive pattern layer LY1. For example, segments of the light emitting control signal line 213 located in different layers are connected through via holes penetrating the insulation layer therebetween.

FIG 12 is a plan view of a display panel provided by an embodiment of the present disclosure. FIG 12 illustrates a first bezel region data line 313a1, a second bezel region data line 313a2, a bezel region light emitting control signal line 213a, and a bezel region gate line 113a.

Referring to FIG 11 and FIG 12, the first portion 3131 of the first bezel region data line 313a1 overlaps with the first portion 1131 of the bezel region gate line 113a in the direction perpendicular to the base substrate BS. Because the sum of the thicknesses of the second gate insulation layer GI2 and the interlayer insulation layer ILD between the first portion 3131 of the first bezel region data line 313a1 and the first portion 1131 of the bezel region gate line 113a is relatively small, the capacitance between the bezel region gate line and the bezel region data line is greatly improved, the missing load of the bezel region gate line is reduced, the load of the bezel region gate line is increased, and the display effect is improved. Generally speaking, the influence of the missing load of the gate line on the display effect is greater than the influence of the missing load of the light emitting control signal line on the display effect.

Referring to FIG 11 and FIG 12, the first portion 3131 of the second bezel region data line 313a2 overlaps with the first portion 2131 of the bezel region light emitting control signal line 213a in the direction perpendicular to the base substrate BS. Therefore, the missing load of the bezel region light emitting control signal line is reduced, the load of the bezel region light emitting control signal line is increased, the display effect is improved, the space occupied by the signal lines in the bezel region at the periphery of the light transmission region is reduced, and a narrow bezel and a higher screen-to-body ratio are realized. For example, as illustrated in FIG 11, the thickness of the first planarization layer PLN1 is greater than the sum of the thicknesses of the second gate insulation layer GI2 and the interlayer insulation layer ILD.

Referring to FIG 11 and FIG 12, the first bezel region data line 313a1 is located in the third conductive pattern layer LY3, and the second bezel region data line 313a2 is located in the fourth conductive pattern layer LY4. An insulation layer is disposed between the third conductive pattern layer LY3 and the fourth conductive pattern layer LY4, and the insulation layer includes a passivation layer PVX and a first planarization layer PLN1. The bezel region gate line 113a is located in the first conductive pattern layer LY1, the bezel region light emitting control signal line 213a is located in the second conductive pattern layer LY2, and a second gate insulation layer GI2 is disposed between the first conductive pattern layer LY1 and the second conductive pattern layer LY2. An interlayer insulation layer ILD is disposed between the second conductive pattern layer LY2 and the third conductive pattern layer LY3. A barrier layer BR and a first gate insulation layer GI1 are disposed between the base substrate BS and the first conductive pattern layer LY1. The first gate insulation layer GI1 is closer to the base substrate BS than the barrier layer BR is. A second planarization layer PLN2 is disposed at a side of the fourth conductive pattern layer LY4 away from the base substrate BS. In the embodiments of the present disclosure, a plurality of elements being located in the same layer refers to that the plurality of elements are formed by the same film layer using the same patterning process. For example, elements located in the first conductive pattern layer LY1 are formed by the same film layer using the same patterning process, elements located in the second conductive pattern layer LY2 are formed by the same film layer using the same patterning process, elements located in the third conductive pattern layer LY3 are formed by the same film layer using the same patterning process, and elements located in the fourth conductive pattern layer LY4 are formed by the same film layer using the same patterning process.

FIG 11 and FIG 12 also illustrate the part 11 of the bezel region gate line 113a overlapping with the bezel region data line 313a, the part 21 of the bezel region light emitting control signal line 213a overlapping with the bezel region data line 313a, the part 31 of the bezel region data line 313a overlapping with the bezel region gate line 113a, and the part 31 of the bezel region data line 313a overlapping with the bezel region light emitting control signal line 213a.

In FIG 11 and FIG 12, the first portion 3131 of the first bezel region data line 313a1 partially overlaps with the first portion 1131 of the bezel region gate line 113a in the direction perpendicular to the base substrate BS. However, in some other embodiments, in order to obtain more overlapping areas and increase the value of compensation capacitance, the orthographic projection of the first portion 3131 of the first bezel region data line 313a1 on the base substrate BS completely covers the orthographic projection of the first portion 1131 of the bezel region gate line 113a on the base substrate BS. For example, in some embodiments, the orthographic projection of the first portion 3131 of the bezel region data line 313a on the base substrate BS completely covers the orthographic projection of the first portion 1131 of the bezel region gate line 113a on the base substrate BS. The data line covering the first portion 1131 of the bezel region gate line 113a can be disposed in a predetermined layer as needed.

In FIG 11 and FIG 12, the first portion 3131 of the second bezel region data line 313a2 partially overlaps with the first portion 2131 of the bezel region light emitting control signal line 213a in the direction perpendicular to the base substrate BS. However, in some other embodiments, in order to obtain more overlapping areas and increase the value of compensation capacitance, the orthographic projection of the first portion 3131 of the second bezel region data line 313a2 on the base substrate BS covers the orthographic projection of the first portion 2131 of the bezel region light emitting control signal line 213a on the base substrate BS. For example, in some embodiments, the orthographic projection of the first portion 3131 of the bezel region data line 313a on the base substrate BS covers the orthographic projection of the first portion 2131 of the bezel region light emitting control signal line 213a on the base substrate BS. The data line covering the first portion 2131 of the bezel region light emitting control signal line 213a can be disposed in a predetermined layer as needed.

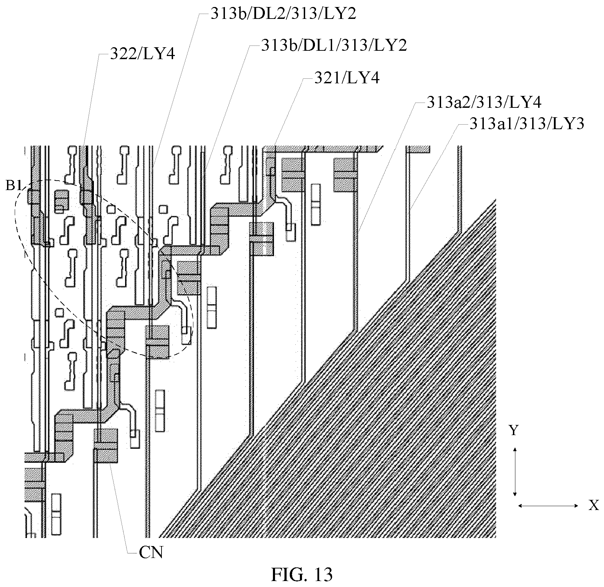

FIG 13 is a plan view of a third conductive pattern layer and a fourth conductive pattern layer in a display panel provided by an embodiment of the present disclosure. As illustrated in FIG 13, the second bezel region data line 313a2 is connected with the display region data line 313b connected thereto at a connection position CN, and the first bezel region data line 313a and the display region data line 313b connected thereto are integrally formed.

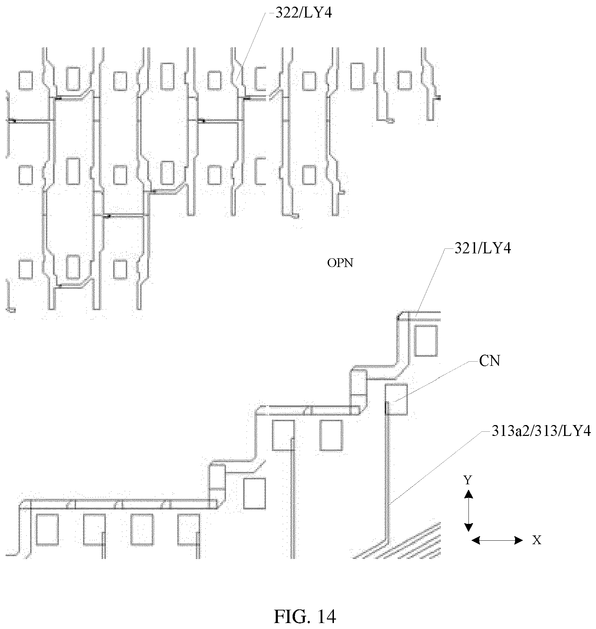

FIG 14 is a plan view of a fourth conductive pattern layer in a display panel provided by an embodiment of the present disclosure. As illustrated in FIG 14, the fourth conductive pattern layer LY4 includes a first conductive line 321, a second bezel region data line 313a2, and a second conductive line 322. The second conductive line 322 may be in a meshed shape, but is not limited thereto. As illustrated in FIG 14, the first conductive line 321 is broken at the light transmission region R1, that is, the first conductive line 321 is disposed around the light transmission region R1 and has an opening OPN at the light transmission region.

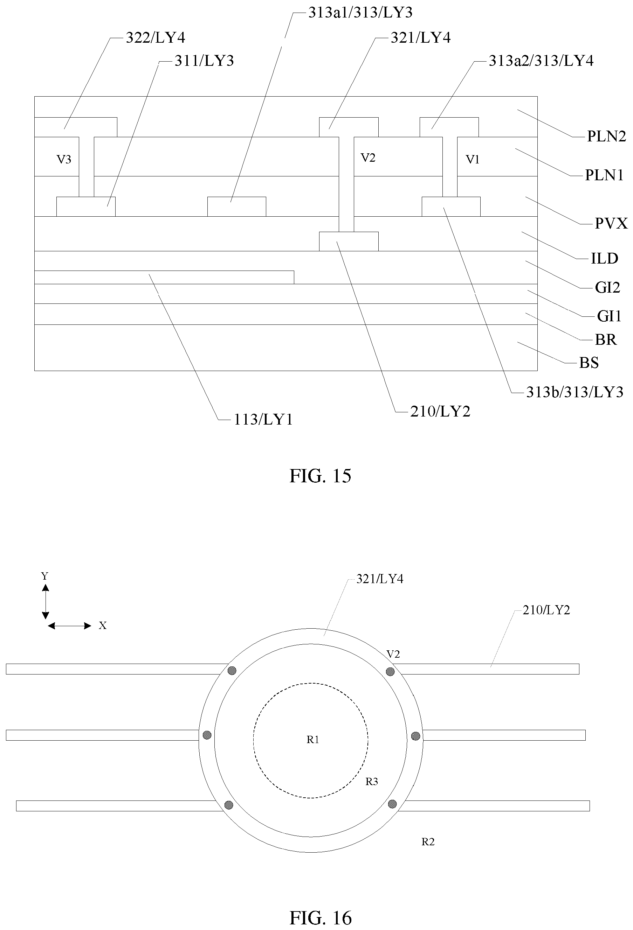

FIG 15 is a cross-sectional view of a display panel provided by an embodiment of the present disclosure. For example, FIG 15 can be a cross-sectional view of a partial structure in the dashed box B1 in FIG 13. As illustrated in FIG 13 and FIG 15, the second bezel region data line 313a2 is connected with one display region data line 313b through a via hole V1 penetrating the first planarization layer PLN1 and the passivation layer PVX.

As illustrated in FIG 15, the second conductive pattern layer LY2 includes an initialization signal line 210, the first conductive line 321 is connected with the initialization signal line 210 through a via hole V2 penetrating the first planarization layer PLN1, the passivation layer PVX and the interlayer insulation layer ILD, and the initialization signal line 210 is connected in parallel with the first conductive line 321 to reduce the resistance of the signal line.

As illustrated in FIG 15, the third conductive pattern layer LY3 includes a first power line 311, and the second conductive line 322 is connected with the first power line 311 through a via hole V3 penetrating the first planarization layer PLN1 and the passivation layer PVX.

For example, as illustrated in FIG 13 and FIG 15, the first bezel region data line 313a1 and the display region data line 313b connected thereto are integrated, and the second bezel region data line 313a2 and the display region data line 313b connected thereto are connected through a via hole V1.

For example, as illustrated in FIG 15, the initialization signal line 210 is located at a side of the gate line 113 away from the base substrate BS, the first conductive line 321 is located in the same layer as the second bezel region data line 313a2, and the first conductive line 321 is connected with the initialization signal line 210 through a via hole V2.

FIG 16 is a plan view of an initialization signal line and a second conductive line in a display panel provided by an embodiment of the present disclosure. For example, as illustrated in FIG 14 and FIG 16, the first conductive line 321 is disposed around the light transmission region R1 and forms an outer boundary of the bezel region R3. The first conductive line 321 in FIG 16 is illustrated as a circle, but the shape of the first conductive line 321 is not limited thereto, and can be arranged as needed. The first conductive line 321 forms a closed structure, such as an annular structure, but is not limited to this case.

For example, referring to FIG 13, FIG 14, and FIG 16, the connection position of the second bezel region data line 313a2 and the display region data line 313b connected thereto is located at the inner side of the first conductive line 321. The inner side of the first conductive line 321 is located within the range enclosed by the first conductive line 321.

For example, referring to FIG 13, FIG 14 and FIG 15, the second conductive line 322 is located in the same layer as the second bezel region data line 313a2, the second conductive line 322 is arranged around the first conductive line 321, and the second conductive line 322 is insulated from the first conductive line 321.

FIG 11 to FIG 15 are illustrated by taking that among the first data line DL1 (referring to FIG 13) and the second data line DL2 (referring to FIG 13) which are adjacent to each other, the first data line DL1 is located in the third conductive pattern layer LY3, the second bezel region data line 313a2 of the second data line DL2 is located in the fourth conductive pattern layer LY4, and other parts of the second data line DL2 are located in the third conductive pattern layer LY3 as an example, but are not limited to this case. In some other embodiments, the first data line DL1 and the second data line DL2 which are adjacent to each other can be located in the third conductive pattern layer LY3 and the fourth conductive pattern layer LY4, respectively. In this case, the second conductive line 322 can extend along the second direction Y in the display region.

FIG 11 to FIG 15 are illustrated by taking that the bezel region gate line 113a overlaps with the first bezel region data line 313a1, and the bezel region light emitting control signal line 213a overlaps with the second bezel region data line 313a2 as an example, but are not limited to this case. In some other embodiments, other arrangements can also be adopted.

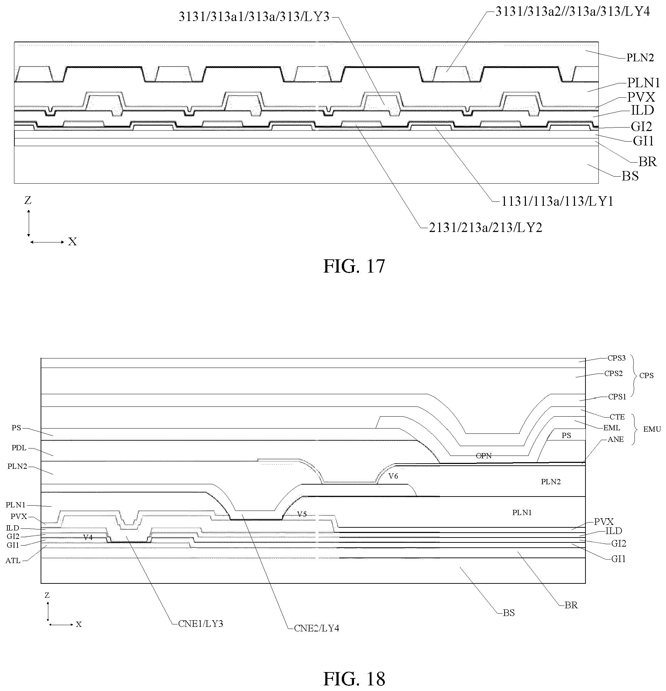

FIG 17 is a cross-sectional view of a display panel provided by an embodiment of the present disclosure. As illustrated in FIG 17, the bezel region gate line 113a overlaps with the second bezel region data line 313a2, and the bezel region light emitting control signal line 213a overlaps with the first bezel region data line 313a1.

Therefore, in the embodiments of the present disclosure, one of the bezel region gate line 113a and the bezel region light emitting control signal line 213a overlaps with the first bezel region data line 313a1, and the other of the bezel region gate line 113a and the bezel region light emitting control signal line 213a overlaps with the second bezel region data line 313a2.

For example, as illustrated in FIG 17, in the bezel region R3, the gate line 113 is closer to the base substrate BS than the light emitting control signal line 213, and a second gate insulation layer GI2 is provided between the gate line 113 and the light emitting control signal line 213. That is, as illustrated in FIG 17, the bezel region gate line 113a is closer to the base substrate BS than the bezel region light emitting control signal line 213a, and a second gate insulation layer GI2 is provided between the bezel region gate line 113a and the bezel region light emitting control signal line 213a.

For example, as illustrated in FIG 17, an interlayer insulation layer ILD is provided between the light emitting control signal line 213 and the first bezel region data line 313a1.

For example, as illustrated in FIG 17, the display panel further includes a second planarization layer PLN2, and the second planarization layer PLN2 covers the second bezel region data line 313a2.

For example, the material of at least one selected from the group consisting of the first bezel region data line 313a1, the second bezel region data line 313a2, the gate line 113, and the light emitting control signal line 213 includes metal or alloy.

FIG 18 is a cross-sectional view of a display panel provided by an embodiment of the present disclosure. The display panel illustrated in FIG 18 illustrates a structure within the display region R2 of the display panel, that is, the structure of a normal light emitting region. For example, as illustrated in FIG 18, the display panel includes a base substrate BS, a barrier layer BR is provided on the base substrate BS; an active layer ATL is provided on the barrier layer BR, the active layer ATL includes a source region, a drain region, and a channel between the source region and the drain region; the source region or the drain region of the active layer ATL is connected with a connection electrode CNE1, the connection electrode CNE1 is connected with the active layer ATL through a via hole V4 penetrating an interlayer insulation layer ILD, a second gate insulation layer GI2 and a first gate insulation layer GI1. The connection electrode CNE1 is located in the third conductive pattern layer LY3, and a passivation layer PVX and a first planarization layer PLN1 are arranged at a side of the third conductive pattern layer LY3 away from the base substrate BS. A connection electrode CNE2 is located in the fourth conductive pattern layer LY4, and the connection electrode CNE2 is connected with the connection electrode CNE1 through a via hole V5 penetrating the passivation layer PVX and the first planarization layer PLN1.

As illustrated in FIG 18, the display panel further includes a light emitting unit EMU, the light emitting unit EMU includes an anode ANE, a light emitting functional layer EML and a cathode CTE; the anode ANE is disposed on the fourth conductive pattern layer LY4, and the anode ANE is connected with the connection electrode CNE2 through a via hole V6 penetrating the second planarization layer PLN2. The display panel further includes an encapsulation layer CPS, and the encapsulation layer CPS includes a first encapsulation layer CPS1, a second encapsulation layer CPS2 and a third encapsulation layer CPS3. For example, the first encapsulation layer CPS1 and the third encapsulation layer CPS3 are inorganic material layers, and the second encapsulation layer CPS2 is an organic material layer.

As illustrated in FIG 18, the display panel further includes a pixel definition layer PDL and a spacer PS. The pixel definition layer PDL includes an opening OPN, the opening OPN is configured to define a light emitting area of the display pixel unit, and the spacer PS is configured to support a fine metal mask when forming the light emitting functional layer EML.

The light emitting unit EMU includes an organic light emitting diode. The light emitting functional layer EML is located between the cathode CTE and the anode ANE. The light emitting functional layer EML at least includes a light emitting layer, and can further includes at least one selected from the group consisting of a hole transport layer, a hole injection layer, an electron transport layer and an electron injection layer.

For example, one of the anode and the cathode of the light emitting unit EMU is electrically connected with a driving transistor, and the driving transistor is configured to provide a driving current for the light emitting unit EMU to drive the light emitting unit EMU to emit light.

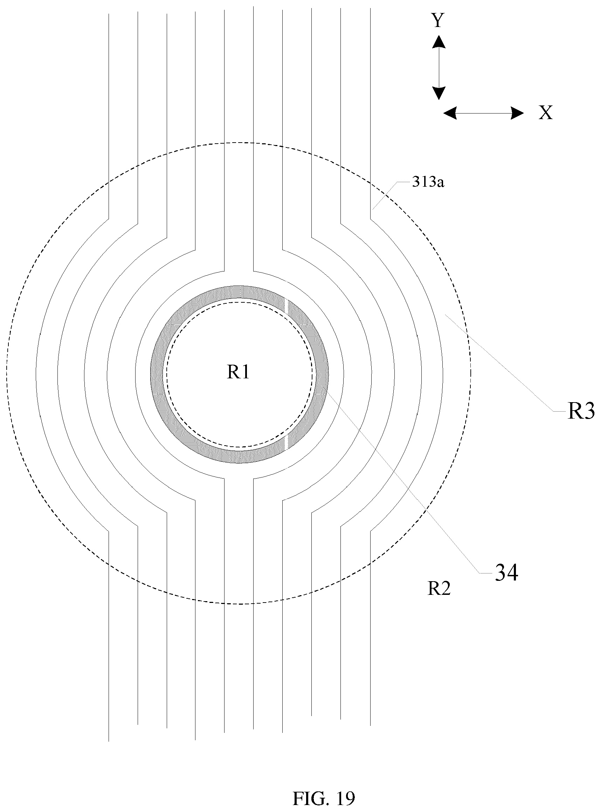

FIG 19 is a partial view of a display panel provided by an embodiment of the present disclosure. For example, as illustrated in FIG 19, the display panel further includes an isolation pillar 34, the isolation pillar 34 is located in the bezel region R3 and arranged around the light transmission region R1, the isolation pillar 34 is located at a side of the plurality of bezel region data lines 313a close to the light transmission region R1, and the isolation pillar 34 forms the inner boundary of the bezel region R3. For example, the isolation pillar 34 is made of a metal material.

For example, the isolation pillar 34 is disposed in the same layer as the first bezel region data line 313a1 or the second bezel region data line 313a2. That is, the isolation pillar 34 is located in the third conductive pattern layer LY3 or in the fourth conductive pattern layer LY4.

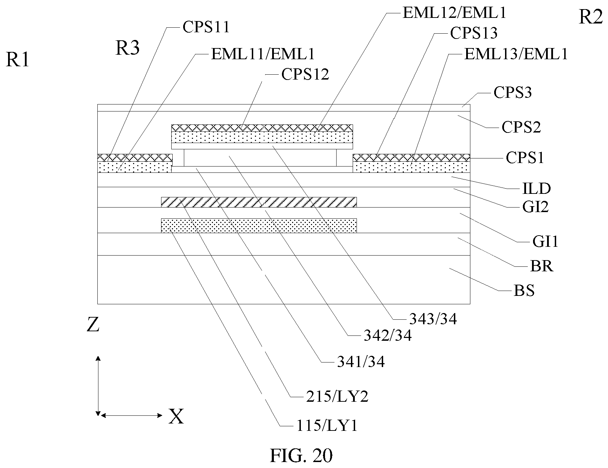

FIG 20 is a partial view of a display panel provided by an embodiment of the present disclosure. As illustrated in FIG 20, the isolation pillar 34 includes a first sub-layer 341, a second sub-layer 342 and a third sub-layer 343, the first sub-layer 341 is closer to the base substrate than the second sub-layer 342, the second sub-layer 342 is closer to the base substrate than the third sub-layer 343, the size of the second sub-layer 342 along a radial direction of the light transmission region R1 is less than the size of the first sub-layer 341 along the radial direction of the light transmission region R1, and the size of the second sub-layer 342 along the radial direction of the light transmission region R1 is less than the size of the third sub-layer 343 along the radial direction of the light transmission region R1. For example, the materials of the first sub-layer 341 and the third sub-layer 343 both include Ti, and the material of the second sub-layer 342 includes Al, but they are not limited thereto.

For example, as illustrated in FIG 20, the organic light emitting diode includes a light emitting functional layer EML1, the light emitting functional layer EML1 includes a first portion EML11 located at a side of the isolation pillar 34 away from the light transmission region R1 and a second portion EML12 located on the isolation pillar 34, and the first portion EML11 of the light emitting functional layer EML1 and the second portion EML12 of the light emitting functional layer are broken at a side edge of the isolation pillar 34. The light emitting functional layer EML1 can be a light emitting functional layer in the form of an entire layer, but is not limited thereto. The light emitting functional layer EML1 can be manufactured by using an opening mask, but is not limited to this case.

Due to the inward arrangement of the second sub-layer 342 in the isolation pillar 34, when the light emitting functional layer EML1 is formed on the isolation pillar 34, the light emitting functional layer EML1 is broken, so that the part of the light emitting functional layer EML1 located in the display region R2 is prevented from being eroded when the external environment such as water and oxygen erodes the light emitting functional layer EML1, and the display effect is prevented from being affected.

For example, as illustrated in FIG 20, the light emitting functional layer EML1 further includes a third portion EML13 located at a side of the isolation pillar 34 away from the light transmission region R1, and the third portion EML13 and the second portion EML12 are broken at a side edge of the isolation pillar 34.

For example, as illustrated in FIG 20, the display panel further includes a first encapsulation layer CPS1, a second encapsulation layer CPS2 and a third encapsulation layer CPS3. The first encapsulation layer CPS1 includes a first portion CPS11 located at a side of the isolation pillar 34 close to the light transmission region R1 and a second portion CPS12 located on the isolation pillar 34, and the first portion CPS11 and the second portion CPS12 are broken at a side edge of the isolation pillar 34. The materials of the first encapsulation layer CPS1, the second encapsulation layer CPS2 and the third encapsulation layer CPS3 can be selected as described above.

For example, as illustrated in FIG 20, the first encapsulation layer CPS1 further includes a third portion CPS13 located at a side of the isolation pillar 34 away from the light transmission region R1, and the third portion CPS13 and the second portion CPS12 are broken at a side edge of the isolation pillar 34.

For example, as illustrated in FIG 20, the second encapsulation layer CPS2 is provided between the first portion EML11 of the light emitting functional layer EML1 and the second portion EML12 of the light emitting functional layer, and the second encapsulation layer CPS2 is provided between the third portion EML13 of the light emitting functional layer EML1 and the second portion EML12 of the light emitting functional layer.

FIG 20 further illustrates an element 115 and an element 215. The element 115 is located in the first conductive pattern layer LY1, and the element 215 is located in the second conductive pattern layer LY2.

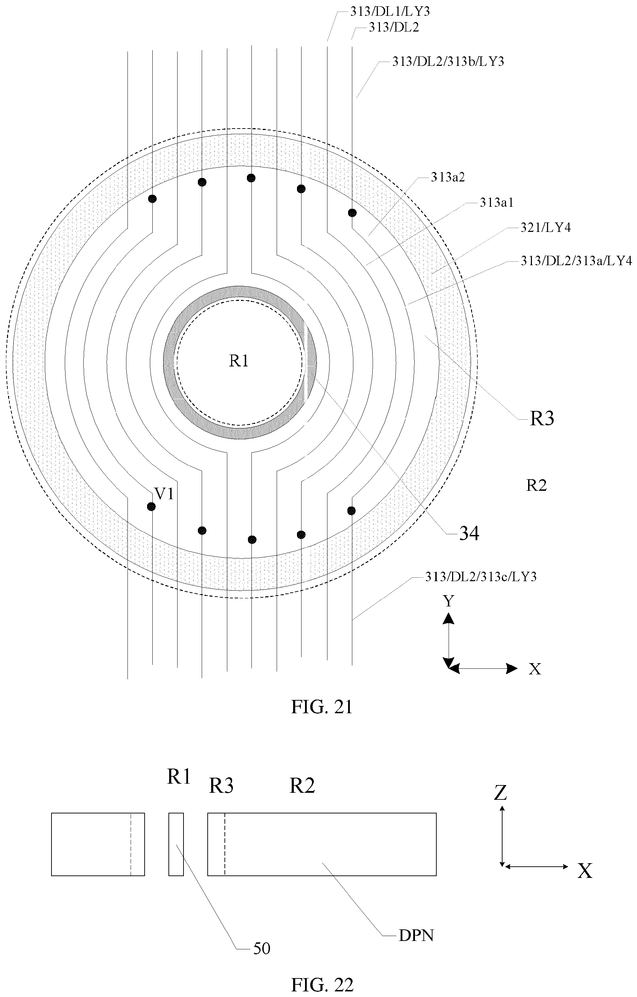

FIG 21 is a partial view of a display panel provided by an embodiment of the present disclosure. Compared with FIG 19, the display panel illustrated in FIG 21 further illustrates a first conductive line 321. As illustrated in FIG 21, the isolation pillar 34 defines the inner boundary of the bezel region R3, and the first conductive line 321 defines the outer boundary of the bezel region R3.

FIG 22 is a schematic diagram of a display panel provided by an embodiment of the present disclosure. As illustrated in FIG 4 and FIG 22, the light transmission region R1 of the display panel DPN is a region where a hole is formed. As illustrated in FIG 22, a sensor 50 is provided in the region where a hole is formed. For example, the sensor 50 can be partially disposed in the region where a hole is formed, or can be entirely disposed in the region where a hole is formed, which is not limited thereto. For example, the sensor includes a camera, but is not limited thereto. After the encapsulation layer is formed, the part of the display panel located in the light transmission region R1 is removed to form a hole, so as to form the display panel.

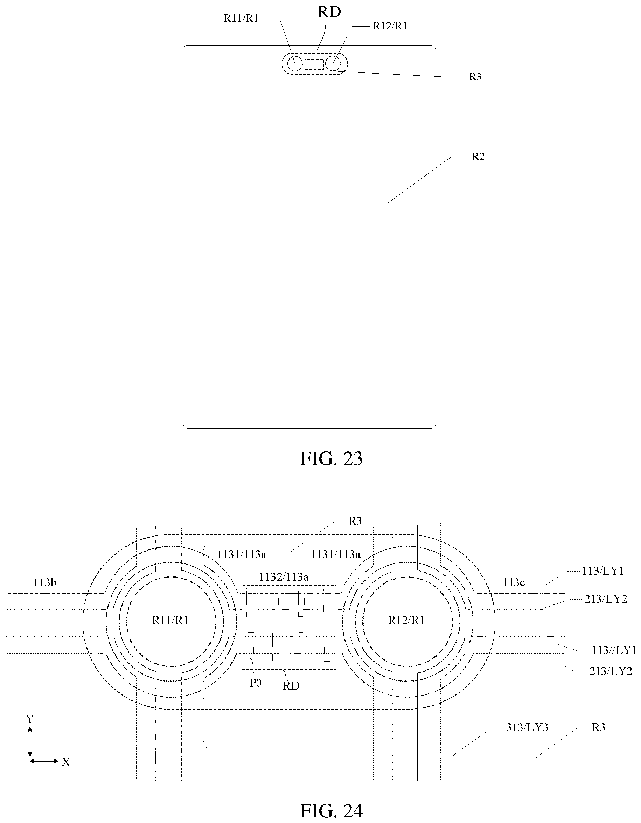

FIG 23 is a schematic diagram of a display panel provided by an embodiment of the present disclosure. As illustrated in FIG 23, the light transmission region R1 includes a first light transmission region R1 and a second light transmission region R12. The first light transmission region R1 and the second light transmission region R12 are both regions in each of which a hole is formed. The region between the first light transmission region R1 and the second light transmission region R12 is also a bezel region R3.

FIG 24 is a partial view of FIG 23. As illustrated in FIG 24, the bezel region gate line 113a includes a second portion 1132 located between the first light transmission region R1 and the second light transmission region R12. The second portion 1132 of the bezel region gate line 113a is provided with a dummy pixel unit to further increase the load of the gate line, reduce the missing load of the gate line, and alleviate or avoid the lateral Mura. FIG 23 and FIG 24 illustrate a dummy region RD, and FIG 24 illustrates a plurality of dummy pixel units P0 located in the dummy region RD. It should be noted that the number of dummy pixel units P0 is not limited to that illustrated in the figure, but can be arranged as needed.

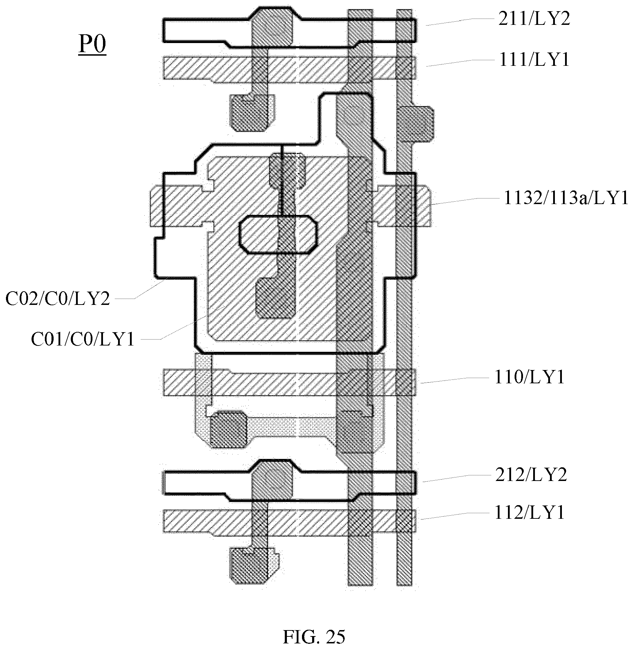

FIG 25 is a plan view of a dummy pixel unit at a second portion of a bezel region gate line. The second portion 1132 of the bezel region gate line 113a is connected with the first electrode plate C01 of the load capacitor C0, and the second electrode plate C02 of the load capacitor C0 is opposite to the first electrode plate C01 of the load capacitor C0. The load capacitor C0 can greatly increase the load of the gate line, which is equivalent to forming, by using the gate line and the second electrode plate C02, a capacitor with a capacitance greater than the capacitance of a storage capacitor C1 (to be described later) of the display pixel unit in the display region. Thus, the load of the gate line (scan signal SCAN) of a dummy pixel unit P0 can be 10-20 times the load in the case where the load capacitor C0 is not provided. For example, according to the capacitance to be compensated and the number of dummy pixel units, the overlapping area of the load capacitor C0 of the dummy pixel unit can be designed to obtain the capacitance to be compensated.

This design makes use of the space where the dummy pixel unit was originally placed, and effectively compensates the capacitance of the gate line in the vicinity of the hole, thus solving the problem of lateral Mura at the hole.

For example, as illustrated in FIG 25, the second portion 1132 of the bezel region gate line 113a and the first electrode plate C01 of the load capacitor C0 are integrally formed, and can be formed by the same film layer using the same patterning process, and both can be located in the first conductive pattern layer LY1. For example, as illustrated in FIG 25, the second portion 1132 of the bezel region gate line 113a and the first electrode plate C01 of the load capacitor C0 are integrated.

For example, as illustrated in FIG 25, the second electrode plate C02 of the load capacitor C0 is connected with the first power line 311, and the first power line 311 is configured to provide a constant voltage signal.

For example, as illustrated in FIG 25, the second electrode plate C02 of the load capacitor C0 partially overlaps with the second portion 1132 of the bezel region gate line 113a.

In FIG 25, the light emitting control signal line 110 is located in the first conductive pattern layer LY1, but is not limited thereto. In some other embodiments, the light emitting control signal line 110 can also be located in the second conductive pattern layer LY2.

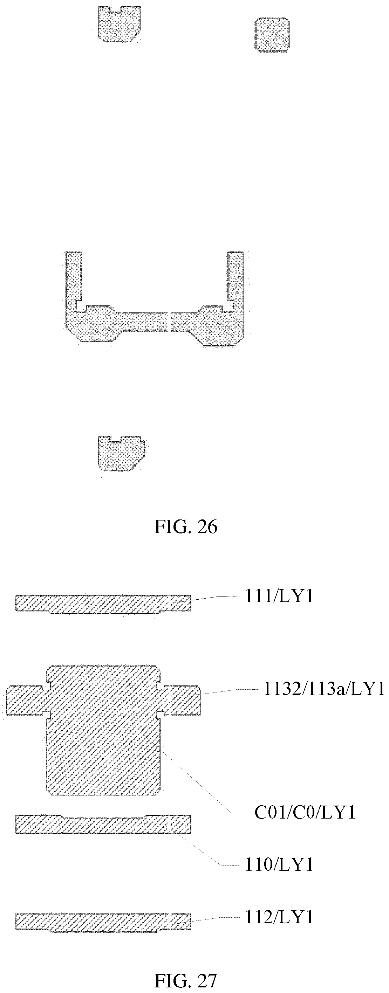

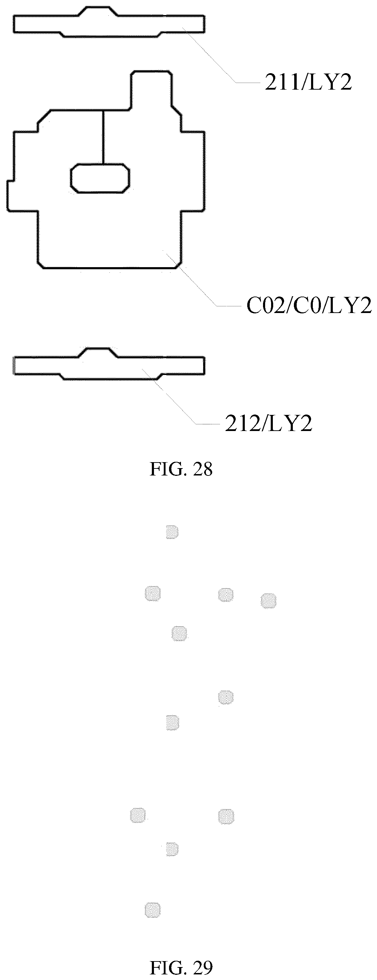

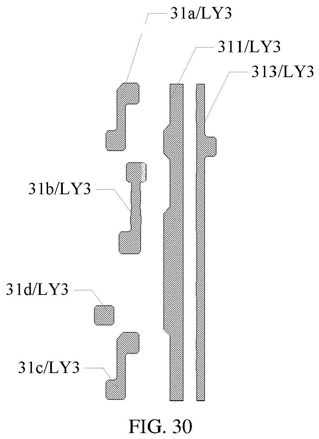

FIG 26 is a pattern of an active layer of the dummy pixel unit in FIG 25. FIG 27 is a pattern of a first conductive pattern layer of the dummy pixel unit in FIG 25. As illustrated in FIG 27, in the first conductive pattern layer LY1, the second portion 1132 of the gate line 113 is integrally formed with the first electrode plate C01 of the load capacitor C0. FIG 28 is a pattern of a second conductive pattern layer of the dummy pixel unit in FIG 25. The second conductive pattern layer LY2 includes the second electrode plate C02 of the load capacitor C0. As illustrated in FIG 28, the second electrode plate C02 of the load capacitor C0 has an opening at the intermediate position thereof. FIG 29 is a pattern of an insulation layer of the dummy pixel unit in FIG 25, and illustrates a via hole penetrating the insulation layer. The insulation layer includes at least one selected from the group consisting of a first gate insulation layer, a second gate insulation layer and an interlayer insulation layer. FIG 30 is a pattern of a third conductive pattern layer of the dummy pixel unit in FIG 25. The third conductive pattern layer LY3 includes a first connection electrode 31a, a second connection electrode 31b, a third connection electrode 31c, a fourth connection electrode 31d, a data line 313, and a first power line 311. For example, in order to increase the load of the gate line, the second connection electrode 31b is connected with the second electrode plate C02 of the load capacitor C0 through a via hole, which is not limited to this case.

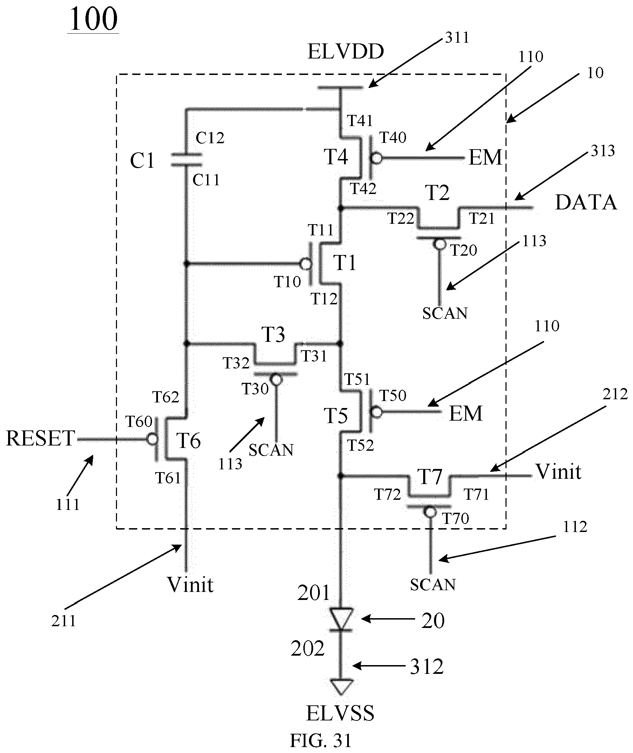

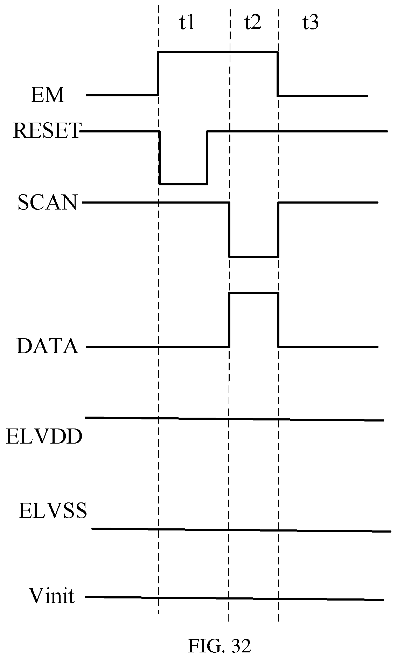

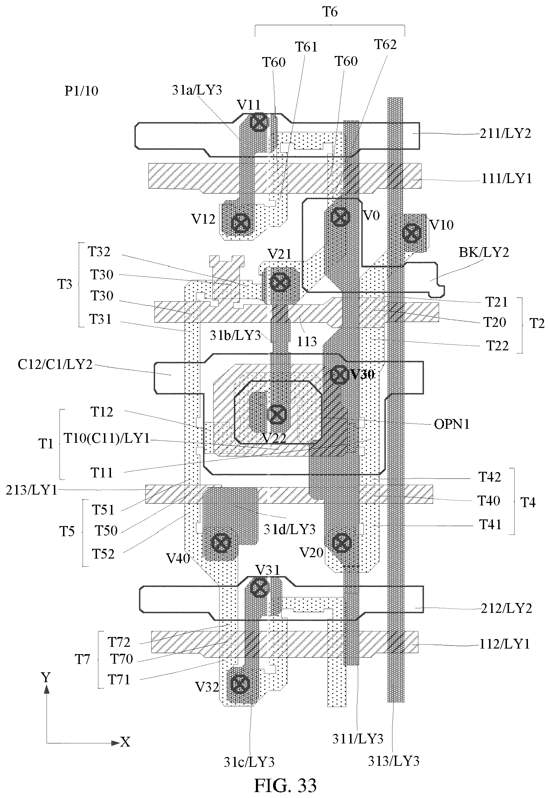

FIG 31 is a schematic diagram of a pixel circuit structure of a display panel provided by an embodiment of the present disclosure. FIG 32 is a timing signal diagram of a pixel unit in a display panel provided by an embodiment of the present disclosure. FIG 33 is a plan view of a display substrate provided by an embodiment of the present disclosure. Referring to FIG 31 and FIG 6, the display panel 100 includes a plurality of display pixel units P1 arranged in a matrix, and each display pixel unit P1 includes a pixel circuit structure 10, a light emitting element 20, a gate line 113, a data line 313 and a voltage signal line. For example, the light emitting element 20 is an organic light emitting diode (OLED), and the light emitting element 20 emits red light, green light, blue light, or white light, etc., under the drive of a pixel circuit structure 10 corresponding thereto. One or a plurality of voltage signal lines can be provided. For example, as illustrated in FIG 31, the voltage signal line includes at least one selected from the group consisting of a first power line 311, a second power line 312, a light emitting control signal line 110, a first initialization signal line 211, a second initialization signal line 212, a first reset control signal line 111, a second reset control signal line 112, etc. The gate line 113 is configured to provide a scan signal SCAN to the pixel circuit structure 10. The data line 313 is configured to provide a data signal DATA to the pixel circuit structure 10. For example, one pixel includes a plurality of pixel units. One pixel can include a plurality of pixel units emitting light of different colors. For example, one pixel includes a pixel unit emitting red light, a pixel unit emitting green light and a pixel unit emitting blue light, but is not limited to this case. The number of pixel units included in one pixel and the light emitting condition of each pixel unit can be determined as needed.

The display pixel unit P1 can emit light. The structure of the dummy pixel unit P0 is formed by omitting some line structure of the display pixel unit P1. For example, the pixel circuit of the dummy pixel unit P0 is incomplete. The pixel circuit of the dummy pixel unit P0 being incomplete refers to that the pixel circuit of the dummy pixel unit P0 may not have at least one of elements or components in the pixel circuit structures 10. The pixel definition layer has no opening at the dummy pixel unit P0, or the dummy pixel unit P0 has no anode, so that the dummy pixel unit P0 does not emit light.

For example, the first power line 311 is configured to provide a constant first voltage signal ELVDD to the pixel circuit structure 10, the second power line 312 is configured to provide a constant second voltage signal ELVSS to the pixel circuit structure 10, and the first voltage signal ELVDD is greater than the second voltage signal ELVSS. The light emitting control signal line 110 is configured to provide a light emitting control signal EM to the pixel circuit structure 10. The first initialization signal line 211 and the second initialization signal line 212 are configured to provide an initialization signal Vint to the pixel circuit structure 10, the first reset control signal line 111 is configured to provide a reset control signal RESET to the pixel circuit structure 10, and the second reset control signal line 112 is configured to provide a scan signal SCAN to the pixel circuit structure 10. The initialization signal Vint is a constant voltage signal, and the magnitude thereof can be between the first voltage signal ELVDD and the second voltage signal ELVSS, but is not limited to thereto. For example, the initialization signal Vint can be less than or equal to the second voltage signal ELVSS.

As illustrated in FIG 31 and FIG 33, the pixel circuit structure 10 includes a driving transistor T1, a data writing transistor T2, a threshold compensation transistor T3, a first light emitting control transistor T4, a second light emitting control transistor T5, a first reset transistor T6, a second reset transistor T7, and a storage capacitor C1. The driving transistor T1 is electrically connected with the light emitting element 20, and outputs a driving current to drive the light emitting element 20 to emit light under the control of signals, such as the scan signal SCAN provide by the gate line 113, the data signal DATA, the first voltage signal ELVDD, the second voltage signal ELVSS, etc.

In the pixel unit of the organic light emitting diode display panel, the driving transistor is connected with the organic light emitting element, and outputs a driving current to the organic light emitting element under the control of signals such as a data signal and a scan signal, etc., so as to drive the organic light emitting element to emit light.

For example, the display panel 100 provided by the embodiments of the present disclosure further includes a data driving circuit and a scan driving circuit. The data driving circuit is configured to provide the data signal DATA to the display pixel unit P1 according to an instruction of a control circuit; the scan driving circuit is configured to provide signals, such as the light emitting control signal EM, the scan signal SCAN, the reset control signal RESER, etc., to the display pixel unit P1 according to an instruction of the control circuit. For example, the control circuit includes an external integrated circuit (IC), but is not limited thereto. For example, the scan driving circuit is a GOA(Gate driver On Array) structure mounted on the display panel, or a driving chip (IC) structure bonding to the display panel. For example, different driving circuits can also be adopted to provide the light emitting control signal EM and the scan signal SCAN, respectively. For example, the display panel 100 further includes a power source (not illustrated in the figure) to provide the above voltage signals, the power source can be a voltage source or a current source as needed, and the power source is configured to provide the first voltage signal ELVDD, the second power voltage ELVSS, the initialization signal Vint, etc., to the display pixel unit P1 through the first power line 311, the second power line 312, and the initialization signal lines (the first initialization signal line 211 and the second initialization signal line 212), respectively.

As illustrated in FIG 31 and FIG 33, the second electrode C12 of the storage capacitor C1 is electrically connected with the first power line 311, and the first electrode C11 of the storage capacitor C1 is electrically connected with the second electrode T32 of the threshold compensation transistor T3. The gate electrode T20 of the data writing transistor T2 is electrically connected with the gate line 113, and the first electrode T21 and the second electrode T22 of the data writing transistor T2 are electrically connected with the data line 313 and the first electrode T11 of the driving transistor T1, respectively. The gate electrode T30 of the threshold compensation transistor T3 is electrically connected with the gate line 113, the first electrode T31 of the threshold compensation transistor T3 is electrically connected with the second electrode T12 of driving transistor T1, and the second electrode T32 of the threshold compensation transistor T3 is electrically connected with the gate electrode T10 of driving transistor T1.

For example, as illustrated in FIG 31 and FIG 33, the gate electrode T40 of the first light emitting control transistor T4 and the gate electrode T50 of the second light emitting control transistor T5 are both connected with the light emitting control signal line 110.

For example, as illustrated in FIG 31 and FIG 33, the first electrode T41 and the second electrode T42 of the first light emitting control transistor T4 are electrically connected with the first power line 311 and the first electrode T11 of the driving transistor T1, respectively. The first electrode T51 and the second electrode T52 of the second light emitting control transistor T5 are electrically connected with the second electrode T12 of the driving transistor T1 and the first electrode 201 of the light emitting element 20, respectively. The second electrode 202 (which may be a common electrode, e.g., cathode, of the OLEDs) of the light emitting element 20 is electrically connected with the second power line 312.

For example, as illustrated in FIG 31 and FIG 33, the gate electrode T60 of the first reset transistor T6 is electrically connected with the first reset control signal line 111, the first electrode T61 of the first reset transistor T6 is electrically connected with the first initialization signal line 211, and the second electrode T62 of the first reset transistor T6 is electrically connected with the gate electrode T10 of the driving transistor T1. The gate electrode T70 of the second reset transistor T7 is electrically connected with the second reset control signal line 112, the first electrode T71 of the second reset transistor T7 is electrically connected with the second initialization signal line 212, and the second electrode T72 of the second reset transistor T7 is electrically connected with the first electrode 201 of the light emitting element 20.

It should be noted that the transistors adopted in any embodiment of the present disclosure can be thin film transistors, field effect transistors or other switching elements with the same characteristics. The source electrode and the drain electrode of a transistor adopted here can be symmetrical in structure, so there may be no difference in structure between the source electrode and the drain electrode. In an embodiment of the present disclosure, in order to distinguish the two electrodes of the transistor other than the gate electrode, it is directly described that one electrode is the first electrode and the other electrode is the second electrode, so the first electrode and the second electrode of all or part of the transistors in the embodiment of the present disclosure can be interchanged as needed. For example, as to the transistor described in the embodiment of the present disclosure, the first electrode can be a source electrode while the second electrode can be a drain electrode. Or, the first electrode of the transistor is a drain electrode while the second electrode of the transistor is a source electrode.

In addition, transistors can be divided into N-type and P-type transistors according to their characteristics. The embodiments of the present disclosure are illustrated by taking that the transistors are P-type transistors as an example. Based on the description and teaching of the implementation of the present disclosure, those skilled in the art can easily think of an implementation in which at least some transistors in the pixel circuit structure of the embodiments of the present disclosure are N-type transistors, that is, N-type transistors or a combination of N-type transistors and P-type transistors are adopted. Therefore, these implementations are also within the protection scope of the present disclosure.

Hereinafter, a driving method of one pixel unit in the display panel provided by an embodiment of the present disclosure will be described with reference to FIG 6 and FIG 32.

As illustrated in FIG 32, within a display time period of one frame, the driving method of the pixel unit includes a first reset phase t1, a data writing and threshold compensation and second reset phase t2, and a light emitting phase t3.

In the first reset phase t1, the light emitting control signal EM is set to be a turn-off voltage; the reset control signal RESET is set to be a turn-on voltage; and the scan signal SCAN is set to be a turn-off voltage.

In the data writing and threshold compensation and second reset phase t2, the light emitting control signal EM is set to be a turn-off voltage; the reset control signal RESET is set to be a turn-off voltage; and the scan signal SCAN is set to be a turn-on voltage.

In the light emitting phase t3, the light emitting control signal EM is set to be a turn-on voltage; the reset control signal RESET is set to be a turn-off voltage; and the scan signal SCAN is set to be a turn-off voltage.

As illustrated in FIG 32, the first voltage signal ELVDD, the second voltage signal ELVSS, and the initialization signal Vint are all constant voltage signals; and the initialization signal Vint is between the first voltage signal ELVDD and the second voltage signal ELVSS.

For example, in the embodiment of the present disclosure, the turn-on voltage refers to a voltage that can cause a first electrode and a second electrode of a corresponding transistor to be turned on, and the turn-off voltage refers to a voltage that can cause a first electrode and a second electrode of a corresponding transistor to be turned off. In the case where the transistor is a transistor of P-type, the turn-on voltage is a low voltage (e.g., 0 V), and the turn-off voltage is a high voltage (e.g., 5 V); in the case where the transistor is a transistor of N-type, the turn-on voltage is a high voltage (e.g., 5 V), and the turn-off voltage is a low voltage (e.g., 0 V). Driving waveforms illustrated in FIG 32 are all described by taking transistors of P-type as an example, that is, the turn-on voltage is a low voltage (e.g., 0 V), and the turn-off voltage is a high voltage (e.g., 5 V).

Referring to FIG 6 and FIG 32 together, in the first reset phase t1, the light emitting control signal EM is at a turn-off voltage; the reset control signal RESET is at a turn-on voltage; and the scan signal SCAN is at a turn-off voltage. In this case, the first reset transistor T6 is in a turn-on state; while the data writing transistor T2, the threshold compensation transistor T3, the first light emitting control transistor T4, and the second light emitting control transistor T5 are in a turn-off state. An initialization signal (an initialization voltage) Vint is transmitted to the gate electrode of the driving transistor T1 by the first reset transistor T6 and then is stored by the storage capacitor C1, so as to reset the driving transistor T1 and eliminate the data stored during emitting light in the last time (a previous frame).

In the data writing and threshold compensation and second reset phase t2, the light emitting control signal EM is at a turn-off voltage; the reset control signal RESET is at a turn-off voltage; and the scan signal SCAN is at a turn-on voltage. In this case, the data writing transistor T2 and the threshold compensation transistor T3 are in a turn-on state; the second reset transistor T7 is in a turn-on state; and the second reset transistor T7 transmits the initialization signal Vint to the first electrode of the light emitting element 20 to reset the light emitting element 20; while the first light emitting control transistor T4, the second light emitting control transistor T5, the first reset transistor T6, and the second reset transistor T7 are in a turn-off state. At this time, the data writing transistor T2 transmits the data signal voltage VDATA to the first electrode of the driving transistor T1, that is, the data writing transistor T2 receives the scan signal SCAN and the data signal DATA and writes the data signal DATA into the first electrode of the driving transistor T1 according to the scan signal SCAN. The threshold compensation transistor T3 is turned on to connect the driving transistor T1 into a diode structure, so that the gate electrode of the driving transistor T1 can be charged. After the charging is completed, a voltage on the gate electrode of the driving transistor T1 is VDATA+Vth, where VDATA is a data signal voltage and Vth is a threshold voltage of the driving transistor T1, that is, the threshold compensation transistor T3 receives the scan signal SCAN and performs threshold voltage compensation on the voltage on the gate electrode of the driving transistor T1. In this phase, a voltage difference between both ends of the storage capacitor C1 is ELVDD-VDATA -Vth.

In the light emitting phase t3, the light emitting control signal EM is at a turn-on voltage; the reset control signal RESET is at a turn-off voltage; and the scan signal SCAN is at a turn-off voltage. The first light emitting control transistor T4 and the second light emitting control transistor T5 are in a turn-on state; while the data writing transistor T2, the threshold compensation transistor T3, the first reset transistor T6, and the second reset transistor T7 are in a turn-off state. The first voltage signal ELVDD is transmitted to the first electrode of the driving transistor T1 through the first light emitting control transistor T4; the voltage on the gate electrode of the driving transistor T1 is maintained at VDATA+Vth; and a light emitting current I flows into the light emitting element 20 through the first light emitting control transistor T4, the driving transistor T1, and the second light emitting control transistor T5, so that the light emitting element 20 emits light. That is, the first light emitting control transistor T4 and the second light emitting control transistor T5 receive the light emitting control signal EM, and control the light emitting element 20 to emit light according to the light emitting control signal EM. The light emitting current I satisfies the following saturation current formula:

$$K(Vgs-Vth)^2=K(VDATA+Vth-ELVDD-Vth)^2=K(VDATA-ELVDD)^2$$

where $K = 0.5\mu_n Cox \dfrac{W}{L}$, $\mu_n$ is channel mobility of the driving transistor, Cox is a channel capacitance per unit area of the driving transistor T1, W and L are a channel width and a channel length of the driving transistor T1, respectively, and Vgs is a voltage difference between the gate electrode and the source electrode (i.e., the first electrode of the driving transistor T1 according to this embodiment) of the driving transistor T1.

It can be seen from the above formula that, the current flowing through the light emitting element 20 is independent of the threshold voltage of the driving transistor T1. Therefore, the pixel circuit structure is very well compensated for the threshold voltage of the driving transistor T1.

For example, a ratio of duration of the light emitting phase t3 to a display time period of one frame may be adjusted. In this way, light emitting brightness may be controlled by adjusting the ratio of the duration of the light emitting phase t3 to the display time period of one frame. For example, the ratio of the duration of the light emitting phase t3 to the display time period of one frame is adjusted by controlling the scan driving circuit 103 in the display panel or a driving circuit additionally provided.

For example, in some other embodiments, the first reset transistor T6 or the second reset transistor T7, etc. may not be provided, that is, the embodiments of the present disclosure are not limited to the specific pixel circuit illustrated in FIG 6, and other pixel circuit that can implement compensation to the driving transistor may be used. Based on the description and teaching of the implementations of the present disclosure, other arrangements that can be easily conceived by those skilled in the art without any inventive work are within the protection scope of the present disclosure.

As illustrated in FIG 33, the data line 313 is electrically connected with the first electrode T21 of the data writing transistor T2 through a via hole V10, the first power line 311 is electrically connected with the first electrode T41 of the first light emitting control transistor T4 through a via hole V20, the first power line 311 is electrically connected with the second electrode C12 of the storage capacitor C1 through a via hole V30, and the first power line 311 is electrically connected with a conductive block BK through a via hole V0.

As illustrated in FIG 33, one end of the first connection electrode 31a is electrically connected with the first initialization signal line 211 through a via hole V11, and the other end of the first connection electrode 31a is electrically connected with the first electrode T61 of the first reset transistor T6 through a via hole V12, so that the first electrode T61 of the first reset transistor T6 is electrically connected with the first initialization signal line 211. One end of the second connection electrode 31b is electrically connected with the second electrode T62 of the first reset transistor T6 through a via hole V21, and the other end of the second connection electrode 31b is electrically connected with the gate electrode T10 of the driving transistor T1 (i.e., the first electrode C11 of the storage capacitor C1) through a via hole V22, so that the second electrode T62 of the first reset transistor T6 is electrically connected with the gate electrode T10 of the driving transistor T1 (i.e., the first electrode C11 of the storage capacitor C1). One end of the third connection electrode 31c is electrically connected with the second initialization signal line 212 through a via hole V31, and the other end of the third connection electrode 31c is electrically connected with the first electrode T71 of the second reset transistor T7 through a via hole V32, so that the first electrode T71 of the second reset transistor T7 is electrically connected with the second initialization signal line 212. The fourth connection electrode 31d is electrically connected with the second electrode T52 of the second light emitting control transistor T5 through a via hole V40. After forming the third conductive pattern layer, the display substrate illustrated in FIG 3 can be obtained.

As illustrated in FIG 33, the second electrode C12 of the storage capacitor C1 has an opening OPN1, so that the other end of the second connection electrode 31b is electrically connected with the gate electrode T10 of the driving transistor T1 through the via hole V22.

The active layer can be formed by firstly forming a semiconductor pattern layer made of semiconductor material and then doping the semiconductor pattern layer with the first conductive pattern layer LY1 as a mask. The doping can adopt a heavy doping. The part of the semiconductor pattern layer covered by the first conductive pattern layer LY1 forms a channel, while the parts of the semiconductor pattern layer not covered by the first conductive pattern layer LY1 are conductive to form the source electrode and the drain electrode of a transistor. For example, the semiconductor material includes poly-silicon, but is not limited thereto.

As illustrated in FIG 33, in order to reduce parasitic capacitance, the first power signal line 311 is narrowed at a position where the first power signal line 311 overlaps with a lateral signal line. For example, the first power signal line 311 is narrowed at a position where the first power signal line 311 overlaps with the gate line 113.

FIG 33 illustrates an active layer, a first conductive pattern layer LY1, a second conductive pattern layer LY2, a third conductive pattern layer LY3, and via holes. The circle with a cross therein in FIG 33 indicates a via hole. Elements in the same conductive pattern layer are formed by the same film layer using the same patterning process.

The pixel circuit of the display substrate illustrated in FIG 33 can be as illustrated in FIG 31. The embodiment of the present disclosure takes that the pixel circuit of the display panel has a 7T1C structure as an example, but is not limited to this case. The pixel circuit of the display substrate can also have a structure including other numbers of transistors, such as a 7T2C structure, a 6T1C structure, a 6T2C structure or a 9T2C structure, which is not limited in the embodiments of the present disclosure.

Referring to FIG 25 and FIG 33, as can be seen in the dummy pixel unit, it is equivalent to that the gate line 113 in the display pixel unit is combined with the first electrode C11 of the storage capacitor C11 to form the first electrode plate of the load capacitor in the dummy pixel unit, so as to provide a relatively large load capacitance.

For example, in the display panel illustrated in FIG 33, a barrier layer BR and a first gate insulation layer GI1 are arranged between the base substrate and the first conductive layer LY1, a second gate insulation layer GI2 is arranged between the first conductive layer LY1 and the second conductive layer LY2, an interlayer insulation layer is arranged between the second conductive layer LY2 and the third conductive layer LY3, and the via hole penetrates at least one of the first gate insulation layer GI1, the second gate insulation layer GI2 or the interlayer insulation layer ILD.

In the embodiment of the present disclosure, the barrier layer BR, the first gate insulation layer GI1, the second gate insulation layer GI2, the interlayer insulation layer ILD, the passivation layer PVX, the first planarization layer PLN1, the second planarization layer PLN2, the pixel definition layer PDL and the support layer PS are all made of insulation materials. For example, the barrier layer BR, the first gate insulation layer GI1, the second gate insulation layer GI2, the interlayer insulation layer ILD and the passivation layer PVX are made of inorganic insulation materials, and the first planarization layer PLN1, the second planarization layer PLN2, the pixel definition layer PDL and the support layer PS can be made of organic insulation materials, but are not limited thereto.

At least one embodiment of the present disclosure further provides a display device, which includes any one of the above display panels.

For example, the display device includes an OLED display device, or any product or apparatus including the OLED display device and having display function, such as a computer, a mobile phone, a watch, an electronic photo-frame, a navigator, etc.

## Claims

1. A display panel, comprising:

a light transmission region (R1);
a display region (R2), arranged around the light transmission region (R1) or at a side of the light transmission region (R1);
a bezel region (R3), located between the light transmission region (R1) and the display region (R2);
a plurality of data lines (313), located on a base substrate (BS), comprising a plurality of bezel region data lines (313a) located in the bezel region (R3) and a plurality of display region data lines (313b) located in the display region (R2), and the plurality of bezel region data lines (313a) being connected with the plurality of display region data lines (313b), respectively;
a plurality of gate lines (113) located on the base substrate (BS), comprising a plurality of bezel region gate lines

(113a) located in the bezel region (R3) and a plurality of display region gate lines (113b) located in the display region (R2), and the plurality of bezel region gate lines (113a) being connected with the plurality of display region gate lines (113b), respectively,

a plurality of light emitting control signal lines (213), the plurality of light emitting control signal lines (213) comprise a plurality of bezel region light emitting control signal lines (213a) located in the bezel region and a plurality of display region light emitting control signal lines (213b) located in the display region,

the plurality of bezel region light emitting control signal lines (213a) are connected with the plurality of display region light emitting control signal lines (213b), respectively,

wherein each of the plurality of bezel region gate lines (113a) comprises a first portion (1131), each of the plurality of bezel region data lines (313a) comprises a first portion (3131), an extending direction of the first portion (1131) of the bezel region gate line (113a) is same as an extending direction of the first portion (3131) of the bezel region data line (313a), and the first portion (1131) of the bezel region gate line (113a) overlaps with the first portion (3131) of one of the plurality of bezel region data lines (313a) in a direction perpendicular to the base substrate (BS),

each of the plurality of bezel region light emitting control signal lines (213a) comprises a first portion (2131), an extending direction of the first portion (2131) of the bezel region light emitting control signal line (213a) is same as the extending direction of the first portion (2131) of the bezel region data line (313a),

and the first portion (2131) of the bezel region light emitting control signal line (213a) overlaps with the first portion (2131) of one of the plurality of bezel region data lines (313a) in the direction perpendicular to the base substrate (BS),

the bezel region data lines (313a) that are adjacent to each other are located in different layers,

the bezel region data lines (313a) that are adjacent to each other comprise a first bezel region data line (313a1) and a second bezel region data line (313a2),

the first bezel region data line (313a1) is closer to the base substrate (BS) than the second bezel region data line (313a2),

and a first insulation layer is arranged between the first bezel region data line (313a1) and the second bezel region data line (313a2);

the bezel region gate line (113a) overlaps with the first bezel region data line (313a1), the bezel region light emitting control signal line (213a) overlaps with the second bezel region data line (313a2),

and a thickness of an insulation layer between the bezel region gate line (113a) and the first bezel region data line (313a1) is less than a thickness of an insulation layer between the bezel region light emitting control signal line (213a) and the second bezel region data line (313a2),

the bezel region gate line is closer to the base substrate than the bezel region light emitting control signal line, and a gate insulation layer is arranged between the bezel region gate line and the bezel region light emitting control signal line.

2. The display panel according to claim 1, wherein a width of a part of the bezel region gate line (113a) overlapping with the bezel region data line (313a) is less than or equal to a width of the bezel region data line (313a); optionally, a length of a part of the bezel region gate line (113a) overlapping with the bezel region data line (313a) along an extending direction of the part of the bezel region gate line (113a) is less than a length of the first portion of the bezel region gate line (113a).

3. The display panel according to any one of claims 1-2, wherein a length of a part of the bezel region gate line (113a) overlapping with the bezel region data line (313a) along an extending direction of the part of the bezel region gate line (113a) is greater than a width of the bezel region data line (313a).

4. The display panel according to any one of claims 1-3, wherein the first portion of the bezel region gate line (113a) comprises a curved portion, and the first portion of the bezel region data line (313a) comprises a curved portion;

optionally, both the curved portion of the bezel region gate line (113a) and the curved portion of the bezel region data line (313a) have an arc shape;

optionally, along a direction pointing from a position away from the light transmission region (R1) to a position close to the light transmission region (R1), a length of a part of the bezel region gate line (113a) overlapping with the bezel region data line (313a) gradually increases.

5. The display panel according to any one of claims 1-4, wherein the first bezel region data line (313a1) and the display region data line connected to the first bezel region data line (313a1) are integrated, and the second bezel region data line (313a2) and the display region data line connected to the second bezel region data line (313a2) are connected through a via hole penetrating the first insulation layer.

6. The display panel according to claim 5, further comprising an initialization signal line (210) and a first conductive line (321), wherein the initialization signal line (210) is located at a side of the plurality of gate lines (113) away from the base substrate (BS), the first conductive line (321) is located in a same layer as the second bezel region data line (313a2), and the first conductive line (321) is connected with the initialization signal line (210); optionally, the first conductive line (321) is arranged around the light transmission region (R1); a connection position of the second bezel region data line (313a2) and the display region data line connected to the second bezel region data line (313a2) is located at an inner side of the first conductive line (321).

7. The display panel according to claim 5 or 6, further comprising a second conductive line (322), wherein the second conductive line (322) is located in a same layer as the second bezel region data line (313a2), the second conductive line (322) is arranged around the first conductive line (321), and the second conductive line (322) and the first conductive line (321) are insulated from each other; optionally, the second conductive line (322) has an opening at the light transmission region (R1).

8. The display panel according to any one of claims 5-7, further comprising a display unit, wherein the display unit comprises an organic light emitting diode, wherein the display panel further comprises an isolation pillar (34), wherein the isolation pillar (34) is located in the bezel region and arranged around the light transmission region (R1), the isolation pillar (34) is located at a side of the plurality of bezel region data lines (313a) close to the light transmission region (R1), and the isolation pillar (34) forms an inner boundary of the bezel region (R3); optionally, the isolation pillar (34) is made of a metal material; wherein the isolation pillar (34) is arranged in a same layer as the first bezel region data line (313a1) or the second bezel region data line (313a2).

9. The display panel according to claim 8, wherein the isolation pillar (34) comprises a first sub-layer (341), a second sub-layer (342) and a third sub-layer (343), the first sub-layer (341) is closer to the base substrate (BS) than the second sub-layer (342), the second sub-layer (342) is closer to the base substrate (BS) than the third sub-layer (343), a size of the second sub-layer (342) along a radial direction of the light transmission region (R1) is less than a size of the first sub-layer (341) along the radial direction of the light transmission region (R1), and the size of the second sub-layer (342) along the radial direction of the light transmission region (R1) is less than a size of the third sub-layer (343) along the radial direction of the light transmission region (R1); optionally, the organic light emitting diode comprises a light emitting functional layer (EML1), the light emitting functional layer (EML1) comprises a first portion (EML11) located at a side of the isolation pillar (34) away from the light transmission region (R1) and a second portion (EML12) located on the isolation pillar (34), and the first portion (EML11) of the light emitting functional layer (EML1) and the second portion (EML12) of the light emitting functional layer (EML1) are broken at a side edge of the isolation pillar (34).

10. The display panel according to any one of claims 1-9, wherein the light transmission region (R1) comprises a first light transmission region (R11) and a second light transmission region (R12), each of the plurality of bezel region gate lines (113a) comprises a second portion, the second portion of the bezel region gate line (113a) is located between the first light transmission region (R11) and the second light transmission region (R12), the second portion of the bezel region gate line (113a) is connected with a first electrode plate (C01) of a load capacitor (C0), and a second electrode plate (C02) of the load capacitor (C0) is opposite to the first electrode plate (C01) of the load capacitor (C0);. optionally, the second electrode plate (C02) of the load capacitor (C0) partially overlaps with the second portion of the bezel region gate line (113a); wherein the second portion of the bezel region gate line (113a) and the first electrode plate (C01) of the load capacitor (C0) are integrated; wherein the display panel further comprises a first power line (311), wherein the first power line (311) is configured to provide a constant voltage signal, and the second electrode plate (C02) of the load capacitor (C0) is connected with the first power line (311).

11. A display device, comprising the display panel according to any one of claims 1-10.

**Patentansprüche**

1. Anzeigetafel, umfassend:

   einen Lichtdurchlassbereich (R1);
   einen Anzeigebereich (R2), der um den Lichtdurchlassbereich (R1) herum oder an einer Seite des Lichtdurchlassbereichs (R1) angeordnet ist;

einen Rahmenbereich (R3), der sich zwischen dem Lichtdurchlassbereich (R1) und dem Anzeigebereich (R2) befindet;

eine Vielzahl von Datenleitungen (313), die sich auf einem Basissubstrat (BS) befinden, umfassend eine Vielzahl von Rahmenbereich-Daten- leitungen (313a), die sich in dem Rahmenbereich (R3) befinden, und eine Vielzahl von Anzeigebereich-Datenleitungen (313b), die sich in dem Anzeigebereich (R2) befinden, wobei die Vielzahl von Rahmenbereich- Datenleitungen (313a) jeweils mit der Vielzahl von Anzeigebereich- Datenleitungen (313b) verbunden sind;

eine Vielzahl von Gate-Leitungen (113), die sich auf dem Basissubstrat (BS) befinden, umfassend eine Vielzahl von Rahmenbereich-Gate-Leitungen (113a), die sich in dem Rahmenbereich (R3) befinden, und eine Vielzahl von Anzeigebereich-Gate-Leitungen (113b), die sich in dem Anzeigebereich (R2) befinden, wobei die Vielzahl von Rahmenbereich-Gateleitungen (113a) jeweils mit der Vielzahl von Anzeigebereich-Gateleitungen (113b) verbunden sind,

eine Vielzahl von Lichtemissions-Steuersignalleitungen (213), wobei die Vielzahl von Lichtemissions-Steuersignalleitungen (213) eine Vielzahl von Rahmenbereich-Lichtemissions-Steuersignalleitungen (213a), die sich in dem Rahmenbereich befinden, und eine Vielzahl von Anzeigebereich-Lichtemissions-Steuersignalleitungen (213b), die sich in dem Anzeigebereich befinden, umfasst,

die Vielzahl von Rahmenbereich-Lichtemissions-Steuersignalleitungen (213a) sind jeweils mit der Vielzahl von Anzeigebereich-Lichtemissions-Steuersignalleitungen (213b) verbunden,

wobei jede von der Vielzahl von Rahmenbereich-Gate-Leitungen (113a) einen ersten Abschnitt (1131) umfasst, jede von der Vielzahl von Rahmenbereich-Datenleitungen (313a) einen ersten Abschnitt (3131) umfasst, eine Ausdehnungsrichtung des ersten Abschnitts (1131) der Rahmenbereich-Gate-Leitung (113a) gleich ist wie eine Ausdehnungsrichtung des ersten Abschnitts (3131) der Rahmenbereich-Datenleitung (313a), und der erste Abschnitt (1131) der Rahmenbereich-Gate-Leitung (113a) überlappt mit dem ersten Abschnitt (3131) von einer von der Vielzahl von Rahmenbereich-Datenleitungen (313a) in einer Richtung senkrecht zu dem Basissubstrat (BS),

jede von der Vielzahl von Rahmenbereich-Lichtemissions-Steuersignalleitungen (213a) einen ersten Abschnitt (2131) umfasst, eine Ausdehnungsrichtung des ersten Abschnitts (2131) der Rahmenbereich-Lichtemissions-Steuersignalleitung (213a) gleich ist wie die Ausdehnungsrichtung des ersten Abschnitts (2131) der Rahmenbereich-Datenleitung (313a),

und der erste Abschnitt (2131) der Rahmenbereich-Lichtemissions-Steuersignalleitung (213a) mit dem ersten Abschnitt (2131) von einer von der Vielzahl von Rahmenbereich-Datenleitungen (313a) in der Richtung senkrecht zu dem Basissubstrat (BS) überlappt,

die einander benachbarten Rahmenbereich-Datenleitungen (313a) sich in unterschiedlichen Schichten befinden,

die einander benachbarten Rahmenbereich-Datenleitungen (313a) eine erste Rahmenbereich-Datenleitung (313a1) und eine zweite Rahmenbereich-Datenleitung (313a2) umfassen,

die erste Rahmenbereich-Datenleitung (313a1) näher an dem Basissubstrat (BS) ist als die zweite Rahmenbereich-Datenleitung (313a2),

und eine erste Isolierschicht zwischen der ersten Rahmenbereich-Datenleitung (313a1) und der zweiten Rahmenbereich-Datenleitung (313a2) angeordnet ist;

die Rahmenbereich-Gate-Leitung (113a) mit der ersten Rahmenbereich-Datenleitung (313a1) überlappt, die Rahmenbereich-Lichtemissions-Steuersignalleitung (213a) mit der zweiten Rahmenbereich-Datenleitung (313a2) überlappt,

und eine Dicke einer Isolierschicht zwischen der Rahmenbereich-Gate-Leitung (113a) und der ersten Rahmenbereich-Datenleitung (313a1) geringer ist als eine Dicke einer Isolierschicht zwischen der Rahmenbereich-Lichtemissions-Steuersignalleitung (213a) und der zweiten Rahmenbereich-Datenleitung (313a2),

die Rahmenbereich-Gate-Leitung näher an dem Basissubstrat ist als die Rahmenbereich-Lichtemissions-Steuersignalleitung, und eine Gate-Isolierschicht zwischen der Rahmenbereich-Gate-Leitung und der Rahmenbereich-Lichtemissions-Steuersignalleitung angeordnet ist.

2. Anzeigetafel gemäß Anspruch 1, wobei eine Breite eines Teils der Rahmenbereich-Gate-Leitung (113a), der sich mit der Rahmenbereich-Datenleitung (313a) überlappt, kleiner oder gleich einer Breite der Rahmenbereich-Datenleitung (313a) ist;

optional eine Länge eines Teils der Rahmenbereich-Gate-Leitung (113a), der sich mit der Rahmenbereich-Datenleitung (313a) entlang einer Ausdehnungsrichtung des Teils der Rahmenbereich-Gate-Leitung (113a) überlappt, kleiner ist als eine Länge des ersten Abschnitts der Rahmenbereich-Gate-Leitung (113a).

**3.** Anzeigetafel gemäß einem der Ansprüche 1 bis 2, wobei eine Länge eines Teils der Rahmenbereich-Gate-Leitung (113a), der sich mit der Rahmenbereich-Datenleitung (313a) entlang einer Ausdehnungsrichtung des Teils der Rahmenbereich-Gate-Leitung (113a) überlappt, größer ist als eine Breite der Rahmenbereich-Datenleitung (313a).

**4.** Anzeigetafel gemäß einem der Ansprüche 1 bis 3, wobei der erste Abschnitt der Rahmenbereich-Gate-Leitung (113a) einen gekrümmten Abschnitt umfasst und der erste Abschnitt der Rahmenbereich-Datenleitung (313a) einen gekrümmten Abschnitt umfasst;

optional sowohl der gekrümmte Abschnitt der Rahmenbereich-Gate-Leitung (113a) als auch der gekrümmte Abschnitt der Rahmenbereich-Datenleitung (313a) eine Bogenform aufweisen;
optional entlang einer Richtung, die von einer Position entfernt von dem Lichtdurchlassbereich (R1) zu einer Position nahe dem Lichtdurchlassbereich (R1) zeigt, eine Länge eines Teils der Rahmenbereich-Gate-Leitung (113a) überlappend mit der Rahmenbereich-Datenleitung (313a) allmählich zunimmt.

**5.** Anzeigetafel gemäß einem der Ansprüche 1 bis 4, wobei die erste Rahmenbereich-Datenleitung (313a1) und die an die erste Rahmenbereich-Datenleitung (313a1) angeschlossene Anzeigebereich-Datenleitung integriert sind und die zweite Rahmenbereich-Datenleitung (313a2) und die an die zweite Rahmenbereich-Datenleitung (313a2) angeschlossene Anzeigebereich-Datenleitung durch ein Durchgangsloch verbunden sind, das die erste Isolierschicht durchdringt.

**6.** Anzeigetafel gemäß Anspruch 5, außerdem umfassend eine Initialisierungssignalleitung (210) und eine erste leitfähige Leitung (321), wobei sich die Initialisierungssignalleitung (210) an einer Seite der Vielzahl von Gate-Leitungen (113) entfernt von dem Basissubstrat (BS) befindet, die erste leitfähige Leitung (321) sich in einer gleichen Schicht wie die zweite Rahmenbereich-Datenleitung (313a2) befindet und die erste leitfähige Leitung (321) mit der Initialisierungssignalleitung (210) verbunden ist;
optional die erste leitfähige Leitung (321) um den Lichtdurchlassbereich (R1) herum angeordnet ist; eine Verbindungsposition der zweiten Rahmenbereich-Datenleitung (313a2) und der an die zweite Rahmenbereich-Datenleitung (313a2) angeschlossenen Anzeigebereich-Datenleitung sich an einer Innenseite der ersten leitfähigen Leitung (321) befindet.

**7.** Anzeigetafel gemäß Anspruch 5 oder 6, außerdem umfassend eine zweite leitfähige Leitung (322), wobei sich die zweite leitfähige Leitung (322) in einer gleichen Schicht wie die zweite Rahmenbereich-Datenleitung (313a2) befindet, die zweite leitfähige Leitung (322) um die erste leitfähige Leitung (321) herum angeordnet ist und die zweite leitfähige Leitung (322) und die erste leitfähige Leitung (321) voneinander isoliert sind;
optional die zweite leitfähige Leitung (322) eine Öffnung an dem Lichtdurchlassbereich (R1) aufweist.

**8.** Anzeigetafel gemäß einem der Ansprüche 5 bis 7, außerdem umfassend eine Anzeigeeinheit, wobei die Anzeigeeinheit eine organische Leuchtdiode umfasst, wobei die Anzeigetafel außerdem einen Isolationspfeiler (34) umfasst, wobei der Isolationspfeiler (34) sich in dem Rahmenbereich befindet und um den Lichtdurchlassbereich (R1) herum angeordnet ist, wobei sich der Isolationspfeiler (34) an einer Seite von der Vielzahl von Rahmenbereich-Datenleitungen (313a) nahe dem Lichtdurchlassbereich (R1) befindet und der Isolationspfeiler (34) eine innere Begrenzung des Rahmenbereichs (R3) bildet;
optional der Isolationspfeiler (34) aus einem Metallmaterial hergestellt ist; wobei der Isolationspfeiler (34) in einer gleichen Schicht wie die erste Rahmenbereich-Datenleitung (313a1) oder die zweite Rahmenbereich-Datenleitung (313a2) angeordnet ist.

**9.** Anzeigetafel gemäß Anspruch 8, wobei der Isolationspfeiler (34) eine erste Unterschicht (341), eine zweite Unterschicht (342) und eine dritte Unterschicht (343) umfasst, wobei die erste Unterschicht (341) näher an dem Basissubstrat (BS) ist als die zweite Unterschicht (342), die zweite Unterschicht (342) näher an dem Basissubstrat (BS) ist als die dritte Unterschicht (343), eine Größe der zweiten Unterschicht (342) entlang einer radialen Richtung des Lichtdurchlassbereichs (R1) kleiner ist als eine Größe der ersten Unterschicht (341) entlang der radialen Richtung des Lichtdurchlassbereichs (R1), und die Größe der zweiten Unterschicht (342) entlang der radialen Richtung des Lichtdurchlassbereichs (R1) kleiner ist als eine Größe der dritten Unterschicht (343) entlang der radialen Richtung des Lichtdurchlassbereichs (R1);
optional die organische Leuchtdiode eine lichtemittierende Funktionsschicht (EML1) umfasst, die lichtemittierende Funktionsschicht (EML1) einen ersten Abschnitt (EML11), der sich an einer Seite des Isolationspfeilers (34) entfernt von dem Lichtdurchlassbereich (R1) befindet, und einen zweiten Abschnitt (EML12), der sich auf dem Isolationspfeiler (34) befindet, umfasst, und der erste Abschnitt (EML11) der lichtemittierenden Funktionsschicht (EML1) und der zweite Abschnitt (EML12) der lichtemittierenden Funktionsschicht (EML1) an einem Seitenrand des Isolationspfeilers (34) unterbrochen sind.

10. Anzeigetafel gemäß einem der Ansprüche 1 bis 9, wobei der Lichtdurchlassbereich (R1) einen ersten Lichtdurchlassbereich (R11) und einen zweiten Lichtdurchlassbereich (R12) umfasst, jede von der Vielzahl von Rahmenbereich-Gate-Leitungen (113a) einen zweiten Abschnitt umfasst, wobei sich der zweite Abschnitt der Rahmenbereich-Gate-Leitung (113a) zwischen dem ersten Lichtdurchlassbereich (R11) und dem zweiten Lichtdurchlassbereich (R12) befindet, der zweite Abschnitt der Rahmenbereich-Gate-Leitung (113a) mit einer ersten Elektrodenplatte (C01) eines Lastkondensators (C0) verbunden ist und eine zweite Elektrodenplatte (C02) des Lastkondensators (C0) der ersten Elektrodenplatte (C01) des Lastkondensators (C0) gegenüberliegt;
optional die zweite Elektrodenplatte (C02) des Lastkondensators (CO) teilweise mit dem zweiten Abschnitt der Rahmenbereich-Gate-Leitung (113a) überlappt; wobei der zweite Abschnitt der Rahmenbereich-Gate-Leitung (113a) und die erste Elektrodenplatte (C01) des Lastkondensators (C0) integriert sind; wobei die Anzeigetafel außerdem eine erste Stromleitung (311) umfasst, wobei die erste Stromleitung (311) konfiguriert ist, um ein konstantes Spannungssignal zu liefern, und die zweite Elektrodenplatte (C02) des Lastkondensators (C0) mit der ersten Stromleitung (311) verbunden ist.

11. Anzeigevorrichtung, umfassend die Anzeigetafel gemäß einem der Ansprüche 1 bis 10.

## Revendications

1. Panneau d'affichage, comprenant :

une région de transmission de lumière (R1) ;
une région d'affichage (R2), agencée autour de la région de transmission de lumière (R1) ou d'un côté de la région de transmission de lumière (R1) ;
une région de cadre (R3), située entre la région de transmission de lumière (R1) et la région d'affichage (R2) ;
une pluralité de lignes de données (313), situées sur un substrat de base (BS), comprenant une pluralité de lignes de données de région de cadre (313a) situées dans la région de cadre (R3) et une pluralité de lignes de données de région d'affichage (313b) situées dans la région d'affichage (R2), et la pluralité de lignes de données de région de cadre (313a) étant reliées respectivement à la pluralité de lignes de données de région d'affichage (313b) ;
une pluralité de lignes de porte (113) situées sur le substrat de base (BS), comprenant une pluralité de lignes de porte de région de cadre (113a) situées dans la région de cadre (R3) et une pluralité de lignes de porte de région d'affichage (113b) situées dans la région d'affichage (R2), et la pluralité de lignes de porte de région de cadre (113a) étant reliées respectivement à la pluralité de lignes de porte de région d'affichage (113b),
une pluralité de lignes de signal de commande d'électroluminescence (213), la pluralité de lignes de signal de commande d'électroluminescence (213) comprenant une pluralité de lignes de signal de commande d'électroluminescence de région de cadre (213a) situées dans la région de cadre et une pluralité de lignes de signal de commande d'électroluminescence de région d'affichage (213b) situées dans la région d'affichage,
la pluralité de lignes de signal de commande d'électroluminescence de région de cadre (213a) sont reliées respectivement à la pluralité de lignes de signal de commande d'électroluminescence de région d'affichage (213b),
dans lequel chacune de la pluralité de lignes de porte de région de cadre (113a) comprend une première partie (1131), chacune de la pluralité de lignes de données de région de cadre (313a) comprend une première partie (3131), une direction d'extension de la première partie (1131) de la ligne de porte de région de cadre (113a) est identique à une direction d'extension de la première partie (3131) de la ligne de données de région de cadre (313a), et la première partie (1131) de la ligne de porte de région de cadre (113a) chevauche la première partie (3131) de l'une de la pluralité de lignes de données de région de cadre (313a) dans une direction perpendiculaire au substrat de base (BS),
chacune de la pluralité de lignes de signal de commande d'électroluminescence de région de cadre (213a) comprend une première partie (2131), une direction d'extension de la première partie (2131) de la ligne de signal de commande d'électroluminescence de région de cadre (213a) est identique à la direction d'extension de la première partie (2131) de la ligne de données de région de cadre (313a),
et la première partie (2131) de la ligne de signal de commande d'électroluminescence de région de cadre (213a) chevauche la première partie (2131) de l'une de la pluralité de lignes de données de région de cadre (313a) dans la direction perpendiculaire au substrat de base (BS),
les lignes de données de région de cadre (313a) qui sont adjacentes les unes aux autres sont situées dans des couches différentes,

les lignes de données de région de cadre (313a) qui sont adjacentes les unes aux autres comprennent une première ligne de données de région de cadre (313a1) et une deuxième ligne de données de région de cadre (313a2),

la première ligne de données de région de cadre (313a1) est plus proche du substrat de base (BS) que la deuxième ligne de données de région de cadre (313a2),

et une première couche d'isolation est agencée entre la première ligne de données de région de cadre (313a1) et la deuxième ligne de données de région de cadre (313a2) ;

les lignes de porte de région de cadre (113a) chevauchent la première ligne de données de région de cadre (313a1), la ligne de signal de commande d'électroluminescence de région de cadre (213a) chevauche la deuxième ligne de données de région de cadre (313a2),

et une épaisseur d'une couche d'isolation entre la ligne de porte de région de cadre (113a) et la première ligne de données de région de cadre (313a1) est inférieure à une épaisseur d'une couche d'isolation entre la ligne de signal de commande d'électroluminescence de région de cadre (213a) et la deuxième ligne de données de région de cadre (313a2),

la ligne de porte de région de cadre est plus proche du substrat de base que la ligne de signal de commande d'électroluminescence de région de cadre, et une couche d'isolation de porte est agencée entre la ligne de porte de région de cadre et la ligne de signal de commande d'électroluminescence de région de cadre.

2. Panneau d'affichage selon la revendication 1, dans lequel une largeur d'une partie de la ligne de porte de région de cadre (113a) chevauchant la ligne de données de région de cadre (313a) est inférieure ou égale à une largeur de la ligne de données de région de cadre (313a) ;

facultativement, une longueur d'une partie de la ligne de porte de région de cadre (113a) chevauchant la ligne de données de région de cadre (313a) selon une direction d'extension de la partie de la ligne de porte de région de cadre (113a) est inférieure à une longueur de la première partie de la ligne de porte de région de cadre (113a).

3. Panneau d'affichage selon l'une quelconque des revendications 1 et 2, dans lequel une longueur d'une partie de la ligne de porte de région de cadre (113a) chevauchant la ligne de données de région de cadre (313a) selon une direction d'extension de la partie de la ligne de porte de région de cadre (113a) est supérieure à une largeur de la ligne de données de région de cadre (313a).

4. Panneau d'affichage selon l'une quelconque des revendications 1 à 3, dans lequel la première partie de la ligne de porte de région de cadre (113a) comprend une partie incurvée, et la première partie de la ligne de données de région de cadre (313a) comprend une partie incurvée ;

facultativement, la partie incurvée de la ligne de porte de région de cadre (113a) et la partie incurvée de la ligne de données de région de cadre (313a) présentent toutes les deux une forme arquée ;

facultativement, selon une direction d'une position éloignée de la région de transmission de lumière (R1) vers une position proche de la région de transmission de lumière (R1), une longueur d'une partie de la ligne de porte de région de cadre (113a) chevauchant la ligne de données de région de cadre (313a) augmente progressivement.

5. Panneau d'affichage selon l'une quelconque des revendications 1 à 4, dans lequel la première ligne de données de région de cadre (313a1) et la ligne de données de région d'affichage reliée à la première ligne de données de région de cadre (313a1) sont intégrées, et la deuxième ligne de données de région de cadre (313a2) et la ligne de données de région d'affichage reliée à la deuxième ligne de données de région de cadre (313a2) sont reliées à travers un trou d'interconnexion pénétrant à travers la première couche d'isolation.

6. Panneau d'affichage selon la revendication 5, comprenant en outre une ligne de signal d'initialisation (210) et une première ligne conductrice (321), dans lequel la ligne de signal d'initialisation (210) est située d'un côté de la pluralité de lignes de porte (113) éloigné du substrat de base (BS), la première ligne conductrice (321) est située dans une même couche que la deuxième ligne de données de région de cadre (313a2), et la première ligne conductrice (321) est reliée à la ligne de signal d'initialisation (210) ;

facultativement, la première ligne conductrice (321) est agencée autour de la région de transmission de lumière (R1) ;

une position de liaison de la deuxième ligne de données de région de cadre (313a2) et de la ligne de données de région d'affichage reliée à la deuxième ligne de données de région de cadre (313a2) est située d'un côté intérieur de la première ligne conductrice (321).

7. Panneau d'affichage selon la revendication 5 ou 6, comprenant en outre une deuxième ligne conductrice (322), dans lequel la deuxième ligne conductrice (322) est située dans une même couche que la deuxième ligne de données de région de cadre (313a2), la deuxième ligne conductrice (322) est agencée autour de la première ligne conductrice (321), et la deuxième ligne conductrice (322) et la première ligne conductrice (321) sont isolées l'une de l'autre ; facultativement, la deuxième ligne conductrice (322) présente une ouverture au niveau de la région de transmission de lumière (R1).

8. Panneau d'affichage selon l'une quelconque des revendications 5 à 7, comprenant en outre une unité d'affichage, dans lequel l'unité d'affichage comprend une diode électroluminescente organique, dans lequel le panneau d'affichage comprend en outre un montant d'isolation (34), dans lequel le montant d'isolation (34) est situé dans la région de cadre et agencé autour de la région de transmission de lumière (R1), le montant d'isolation (34) est situé d'un côté de la pluralité de lignes de données de région de cadre (313a) proche de la région de transmission de lumière (R1), et le montant d'isolation (34) forme une limite intérieure de la région de cadre (R3) ;
facultativement, le montant d'isolation (34) est constitué d'un matériau métallique ; dans lequel le montant d'isolation (34) est agencé dans une même couche que la première ligne de données de région de cadre (313a1) ou que la deuxième ligne de données de région de cadre (313a2).

9. Panneau d'affichage selon la revendication 8, dans lequel le montant d'isolation (34) comprend une première sous-couche (341), une deuxième sous-couche (342) et une troisième sous-couche (343), la première sous-couche (341) est plus proche du substrat de base (BS) que la deuxième sous-couche (342), la deuxième sous-couche (342) est plus proche du substrat de base (BS) que la troisième sous-couche (343), une taille de la deuxième sous-couche (342) selon une direction radiale de la région de transmission de lumière (R1) est inférieure à une taille de la première sous-couche (341) selon la direction radiale de la région de transmission de lumière (R1), et la taille de la deuxième sous-couche (342) selon la direction radiale de la région de transmission de lumière (R1) est inférieure à une taille de la troisième sous-couche (343) selon la direction radiale de la région de transmission de lumière (R1) ;
facultativement, la diode électroluminescente organique comprend une couche fonctionnelle électroluminescente (EML1), la couche fonctionnelle électroluminescente (EML1) comprend une première partie (EML11) située d'un côté du montant d'isolation (34) éloigné de la région de transmission de lumière (R1) et une deuxième partie (EML12) située sur le montant d'isolation (34), et la première partie (EML11) de la couche fonctionnelle électroluminescente (EML1) et la deuxième partie (EML12) de la couche fonctionnelle électroluminescente (EML1) sont interrompues au niveau d'un bord latéral du montant d'isolation (34).

10. Panneau d'affichage selon l'une quelconque des revendications 1 à 9, dans lequel la région de transmission de lumière (R1) comprend une première région de transmission de lumière (R11) et une deuxième région de transmission de lumière (R12), chacune de la pluralité de lignes de porte de région de cadre (113a) comprend une deuxième partie, la deuxième partie de la ligne de porte de région de cadre (113a) est située entre la première région de transmission de lumière (R11) et la deuxième région de transmission de lumière (R12), la deuxième partie de la ligne de porte de région de cadre (113a) est reliée à une première plaque d'électrode (C01) d'un condensateur de charge (C0), et une deuxième plaque d'électrode (C02) du condensateur de charge (C0) est opposée à la première plaque d'électrode (C01) du condensateur de charge (C0) ;
facultativement, la deuxième plaque d'électrode (C02) du condensateur de charge (C0) chevauche partiellement la deuxième partie de la ligne de porte de région de cadre (113a) ; dans lequel la deuxième partie de la ligne de porte de région de cadre (113a) et la première plaque d'électrode (C01) du condensateur de charge (C0) sont intégrées ; dans lequel le panneau d'affichage comprend en outre une première ligne d'alimentation (311), dans lequel la première ligne d'alimentation (311) est configurée pour fournir un signal de tension constante, et la deuxième plaque d'électrode (C02) du condensateur de charge (C0) est reliée à la première ligne d'alimentation (311).

11. Dispositif d'affichage, comprenant le panneau d'affichage selon l'une quelconque des revendications 1 à 10.

FIG. 1

FIG. 2

FIG. 3

FIG. 4

FIG. 5

FIG. 6

FIG. 7

FIG. 8

R2

1131

2131

113b

213b

113a   113c   113/LY1

213a   213c   213/LY2

R1

113//LY1

213/LY2

Y

X

R3

FIG. 9

31/3131/313a/313/LY3

PLN1

PVX

ILD

GI2

GI1

BR

BS

Z

X

11/1131/113a/113/LY1   21/2131/213a/213/LY2

FIG. 10

313a2/313a/313/LY4

PLN2
PLN1
PVX
ILD
GI2
GI1
BR
BS

31

21
313a1/313/313/LY3
11
213a/213/LY2
113a/113/LY1

Z

X

FIG. 11

3131/313a2/313/LY4

3131/313a1/313/LY3

2131/213a/213/LY2
21/31
1131/113a/113/LY1
11/31

Y

X

FIG. 12

FIG. 13

322/LY4

321/LY4

OPN

CN

313a2/313/LY4

Y

X

FIG. 14

322/LY4

313a1/313/LY3

321/LY4

311/LY3

313a2/313/LY4

PLN2

V3

V2

V1

PLN1

PVX

ILD

GI2

GI1

BR

BS

313b/313/LY3

113/LY1

210/LY2

FIG. 15

Y

X

321/LY4

210/LY2

V2

R1

R3

R2

FIG. 16

FIG. 17

FIG. 18

FIG. 19

FIG. 20

FIG. 21

FIG. 22

EP 4 002 342 B1

FIG. 23

FIG. 24

P0

211/LY2

111/LY1

1132/113a/LY1

C02/C0/LY2

C01/C0/LY1

110/LY1

212/LY2

112/LY1

FIG. 25

FIG. 26

111/LY1

1132/113a/LY1

C01/C0/LY1

110/LY1

112/LY1

FIG. 27

211/LY2

C02/C0/LY2

212/LY2

FIG. 28

FIG. 29

FIG. 30

FIG. 31

FIG. 32

FIG. 33

**EP 4 002 342 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 110208994 A
- CN 109767689 A
- US 2019285954 A1
- US 2019319212 A1